# EUROPEAN PATENT SPECIFICATION

(11) **EP 1 713 083 B1**
(45) Date of publication and mention of the grant of the patent: **21.02.2018**
(21) Application number: 05425207.7
(22) Date of filing: 11.04.2005
(51) Int. Cl.: G11C 16/16

(54) **Non-volatile memory electronic device with NAND structure being monolithically integrated on semiconductor**
Integriete Schaltung mit nichflüchtigem Speicher des NAND-Typs
Circuit intégré à mémoire non volatile de structure NAND

(43) Date of publication of application: 18.10.2006
(73) Proprietor: Micron Technology, Inc., Boise, ID 83707 (US)
(72) Inventor: Pascucci, Luigi, 20099 Sesto S. Giovanni (Milano) (IT); Rolandi, Paolo, 27058 Voghera (Pavia) (IT)
(74) Representative: Carpmaels & Ransford LLP

(56) References cited:
- US-A- 5 553 016
- US-A- 5 732 018
- US-A- 6 115 315
- US-A1- 2002 186 591

## Description

### Field of application

The present invention relates to a memory electronic device, which is, for example, monolithically integrated on a semiconductor and of the Flash EEPROM type with an architecture of the NAND type comprising at least one memory matrix organised in memory cell rows and columns.

The invention also relates to a method for programming the above memory device.

### Background of the Invention

It is known that the market of non-volatile memories, for example of the EEPROM or Flash EEPROM type, is currently growing a lot and the most promising applications relate to the "data storage" field.

Until a few time ago, such market almost exclusively involved the consumer field of the digital cameras, with the relative support cards, or the known USB keys which represented expansion mobile memories for personal computers.

Therefore, the demand for these products by the consumer market was mainly addressed to flash memories of great capacity.

This trend seems to be also destined to reinforce in the next years by virtue of the newer and newer applications of the portable electronic devices which require a higher and higher memory capacity, for example for digital cameras or for mobile phones of the last generation operating for example according to the standard 3G or UMTS.

These applications are completely compatible with the natural evolution of the Flash memories if one considers that such memories are substantially solid-state mass memory units with further advantages linked to their low consume, to the operation stillness, to the reduced space etc..

As it is well known to the skilled person in the art, the Flash memory architectures are substantially referred to two fundamental paths, the first of which refers to the traditional and widely tested NOR architectures, whereas the second one refers to the more innovative and promising NAND architectures.

For the previously cited applications the flash architecture being most suitable to the requirements of low consume, high density, high program and/or erase speed, is certainly that of the NAND type.

This kind of architecture exhibits obvious advantages with respect to the NOR architectures. In particular Flash memories with NAND architecture are faster in the data storage activities and in managing big amounts of data to be restored in a synchronous way and this makes them more suitable to the use for the applications on portable electronic devices.

Since in the data storage applications the need of a random access time is less important with respect to the case of "code storage" applications, the most significant feature of the architectures of the NOR type loses most of its importance to the advantage of the NAND architecture which exactly allows to treat great amounts of "synchronous" data in reading and programming in a simple and quick way.

However, although having the feature of a brilliant data modify speed, such NAND memories do not allow a fast random access to the same, since they are oriented to readings of entire pages of at least 512 bytes, but not of the single bytes. In fact, the NAND access protocol is quite slow in random access due to the known latency time and it exhibits serious difficulties for acceding into a sector or a page in a random way.

For meeting the increasing needs of portable electronic devices it would be necessary to have in a same memory also an excellent random access time, such as to perform the code or the boot of the operative system or of the programs without the burdensome help of a RAM.

Recently, further new needs have arisen linked to the games and cellular phones market, which stay in the availability of high capacity memories, to store any kind of datum, but also to store an operative system, video, programs, results etc.

To meet these needs the known technique has recently proposed devices defined as MCP (Multi Chip Package) which incorporate, in a single package, different integrated electronic circuits such as for example several types of memory circuits, for example one Flash memory of the NAND type, one of the NOR type and one RAM memory.

All these memories are assembled and supplied in a single package so as to provide a single device simultaneously having the advantages of all the memories on the market, for example density and storage capability as regards the NAND portion, or access speed and XIP possibility as regards the NOR portion, random access as regards the RAM portion.

One of these devices is commercially known with the acronym OneNAND and manufactured by Samsung; another example of this kind of Multi Chip Package is the "DiskOnChip" of M-System.

Although advantageous under several aspects, and substantially meeting the aim, these devices are not exempt from drawbacks.

First of all it is to be considered that the various memory circuits to be assembled in a single package are realised with different technologies which oblige to solve problems of compatibility in the supplies on a single package and in the management of the input/output signals.

Secondly, the costs of the resulting package cannot detach a lot from the global cost of the various components, since they cannot exploiting great scale economies in the realisation of devices assembled with components being different from one another.

There exist, then, all a series of problems which the present invention intends to face starting from the assumption that only a detailed comprehension of the phenomena apt to the memorisation of the datum inside the memory cells can allow to understand the intrinsic limits of the adopted technology.

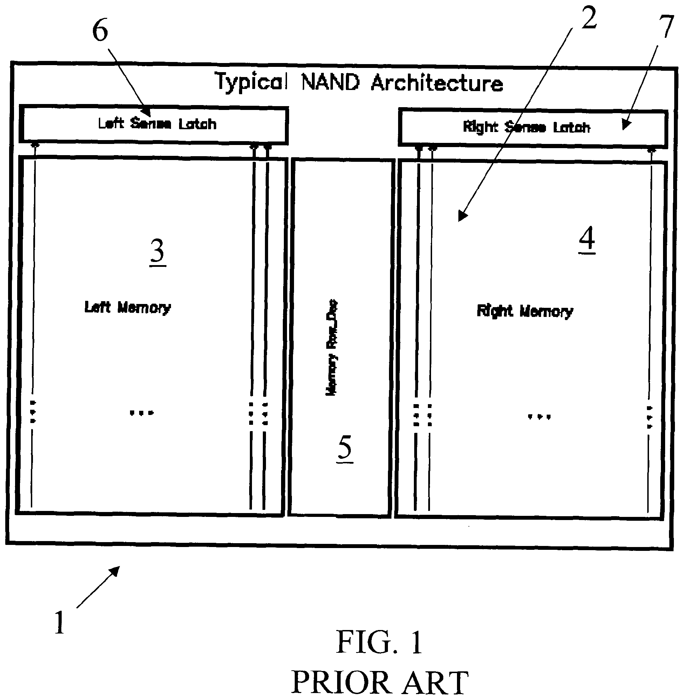

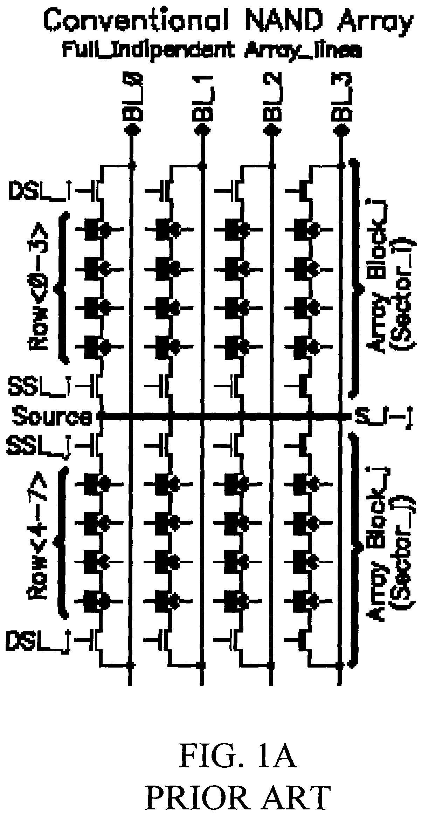

For example, in the herewith attached figure 1 the structure is shown of a non volatile memory device 1 integrated on semiconductor and comprising a NAND memory matrix 2 of the traditional non volatile type made of a plurality of blocks or physical sectors organised in cell rows and columns.

This type of architecture provides a very ordinate structure of memory cells divided in two sub-matrixes 3 and 4, left L and right R, making reference to a single row decoding block 5 centrally arranged in the device 1.

A bank of registers of the read amplifiers or sense amplifiers 6 and 7 corresponds to each sub-matrix L, R.

In figure 1A, by way of illustration only, the matrix 2 is shown with blocks i and j of only four rows, which, however, are practically made of at least 16 rows and four columns.

Each row or word line ROW <0:3> of a given n-th block of the matrix corresponds to a respective row driver.

It can be also appreciated that the cells of a given block or sector i, j ... have a common source line and they are connected to a respective bit line and to the common source line by means of respective drain (DSL) and source (SSL) selectors.

In summary, in the architectures of the traditional type the word lines of a matrix, both of the NOR type and of the NAND type, are independent from each other and the potential for selecting the cell to be read or programmed is applied to one and only matrix row.

This approach necessarily implies dedicated decoding networks for each sector with an increase in the number of lines and of transistors.

This field suffers from the length of the memory cell arrays which require high propagation times in the reading step for allowing to reach also the cells being farthest from the node to which the reading potential is applied.

Moreover, within the scope of the present invention it is also to be noted that the lithographic sizes for the manufacturing of non volatile memories have reached limits lower than about 65nm, or even than 32nm, such as to make not only the construction of the interface between the decoding circuitry and the matrix of the cells themselves difficult, but also such as to enormously increase the propagation times of the signals due to the lines length.

In this respect, an important role is played by the row decoding, whose architecture enormously conditions both the sizes, and the access time of the memory. This is particularly true where the row lines reach the extreme compactness levels, mainly in the Flash of the NAND type, the problem becomes extreme and the implementation complex to such an extent as to make the area occupation inefficient.

The program and erase operations occur by exploiting the Fowler-Nordheim phenomenon, while the reading is an operation of the dynamic type.

Well, even due to this the reading step is slowed down a lot.

It is to be remembered that in a sector of the NAND type the smallest erase unit is made of a group of word lines equal to the number of cells of the stack included between the SSL and DSL lines which intercept them, i.e. 16 or 32 according to the memory sizes.

This implies that each stack elemental structure has a very reduced conductivity being thus a great limitation to the reading speed. The conventional stack structure (16,32 cells) is thus intimately slow since it is little conductive.

Finally, it is to be signalled that current NAND memories do not allow to perform an operative code, for example of the XIP type, since the random access time typical of these architectures is in the order of 10-20usec.

The reason of such slowness is due to the particular organisation of the matrix which normally comprises groups of 16/32 cells in series which strongly reduce its conductivity, connected to each other through long selector lines which remarkably decrease their propagations with long bit-lines which strongly burden the load.

The increase of the load due to the BL is enormously greater than in the corresponding NOR-Flash since in the NAND-Flash the generic BL collects the capacities of all the stack structures which, combined with the great capacities of the memory, remarkably increase its value. The invention also aims at obviating also to this drawback by adopting a solution which will be hereafter described.

Document US 2001/0038118 A1 discloses a non-volatile memory including a memory cell array with a plurality of NAND-type memory cell units. A bit line side switching portion is connected between a NAND-type memory cell column and a bit line and a source line side switching portion connected between the memory cell and a source line. Two of NAND-type memory cell units are respectively connected to the identical bit line via the bit line switch.

From US patent application US 2002/0186591 A1 a semiconductor memory device is known. The device has a main memory cell array and a sub-memory cell array. The sub-memory cell array provides a higher data read speed than the main memory cell array.

US 6 115 315 A discloses the features of the preamble of the independent claims, namely a semiconductor memory device including a first memory cell consisting of a single-gate transistor and a stacked-gate transistor and a second memory cell consisting of a stacked-gate transistor, and is constructed such that a memory cell array composed of the first memory cells and a memory cell array composed of the second memory cells share peripheral circuits. Accordingly, the first stacked-gate transistor constituting the first semiconductor memory cell and the second stacked-gate transistor constituting the second semiconductor memory cell can be operated using the same voltages.

A technical problem underlying the present invention is that of providing a new matrix architecture for a non volatile memory electronic device of the monolithically integrated type, i.e. realised on a single chip, having such structural and functional features as to incorporate a memory matrix divided into at least one pair of portions having different data storage capacity and different access speed.

A further aim of the invention is that of providing a memory device of the indicated type and having structural and functional features of greater compactness and such as to simplify the modes of access to the memory overcoming the limits and the drawbacks of the solutions proposed by the known technique.

Another aim of the present invention is that of providing a new type of memory electronic device having such structural and functional features as to offer the same performances as a Multi Chip Package however overcoming the limits and the drawbacks of that type of solution.

A further aim of the present invention is that of providing a new type of memory electronic device wherein the two portions of memory matrix having different data storage capacity and different access speed can exploit the same structural sources but can be decoupled according to the operation needs by the user.

Still a further aim of the invention is that of providing the introduction, with respect to the traditional methods, of a selection of the matrix rows so as to minimise the cell network and easy the realisation thereof.

### Summary of the Invention

According to a first aspect, the present invention provides a non-volatile memory in accordance with the subject-matter of independent claim 1. According to a second aspect, the present invention provides a method for operating a non-volatile memory in accordance with the subject-matter of independent claim 14. Preferred embodiments of the present invention are set forth in the dependent claims, the following description and the drawings.

A solution idea underlying the present invention is that of realising a memory integrated architecture having at least two areas or portions with different data storage capacity and different access speed which exhibit continuity between the bit lines structures and share both the read and program resources, which maintain the same protocol and operative management procedures, which tolerate different propagation and conductivity times in the two sections.

More in particular, the invention provides to realise a memory integrated architecture whose fastest section includes measures suitable to improve its conductivity, to reduce the propagations, to minimise the load.

More in detail, the same fastest section implies physical sectors melted with each other by multiple of two, four, etc. short-circuiting the pairs of word lines with each other, for example short-circuiting a row of a physical sector with a corresponding row of the adjacent physical sector, thus obtaining a logic sector which becomes the smallest unit entirely erasable by the new architecture. In any case the unicity of the datum is maintained in each array cell safeguarding in the meantime the functionality of the structure, the correspondence between the rows being moreover definable according to the needs of the device layout.

The features and advantages of the memory electronic device and of the relative programming method according to the invention will be apparent from the following description of an embodiment thereof given by way of indicative and non limiting example with reference to the annexed drawings.

### Brief description of the drawings

- figure 1 shows a schematic view of memory electronic device, in particular an EEPROM memory with NAND architecture realised according to the prior art;
- figure 1A shows a schematic view of a portion of memory electronic device, in particular an EEPROM memory with NAND architecture realised according to the prior art;
- figure 2 shows a schematic view of a memory electronic device, in particular an EEPROM memory with NAND architecture realised according to the present invention;
- figure 3 shows a schematic view of the memory electronic device according to the present invention where a measure is highlighted for decoupling the bit lines shared by two portions of the cell matrix;
- figure 4 shows a further schematic view of the device of figure 3;
- figure 4A shows a schematic view of a detail of the memory electronic device according to the invention;
- figure 5 shows a schematic block view and in greater detail of a portion of the device of figure 3;
- figure 6 shows a schematic view of a portion of the memory electronic device, in particular an EEPROM memory with NAND architecture, realised according to the present invention;
- figure 7 shows a further way to illustrate the same memory portion according to the present invention already shown in fig. 6 and highlighting the biasing values of bit lines in the programming step;
- figure 8 shows a schematic view of a portion of memory electronic device realised according to the best realisation mode of the present invention by means of a different coupling of word lines with respect to the example of figure 7;
- figure 9 shows a comparative table reporting the biasing values of the row and column selectors of the well region wherein the memory cells are realised for a matrix portion of the conventional type and for the matrix portion according to the invention respectively;
- figure 10 shows a schematic view of the portion of figure 7 during the reading step of a memory cell;
- figure 11 shows a schematic view of the portion of figure 7 during the erasing step of a sector of the memory matrix;
- figure 12 shows a schematic view of the portion of figure 7 during the programming step of the content of a memory cell;
- figure 13 shows, on a diagram with same time basis, the trend of a group of signals of the programming step of the memory matrix portion according to the invention for optimising the functionality thereof;
- figure 14 shows a schematic view of a portion of the memory device according to the invention wherein a single selector block is provided for two word line groups;
- figure 15 shows a schematic view of the device of figure 3 wherein the fluidification technique of the propagations according to the WL by means of the metal strap on the word lines of the fast memory portion is highlighted;
- figures 16 and 17A and 17B show respective schematic views of an embodiment of strap techniques for the device according to the invention;
- figure 18A shows a schematic view of a possible edge strap technique for the device of the present invention;
- figure 18B shows a schematic view of a possible edge strap and of full middle strap technique for the device of the present invention;
- figures 19 e 20 show respective schematic views of further embodiments of strap techniques for the device according to the invention;
- figure 21 shows a schematic view of the device of figure 3 wherein portions of slow, fast and intermediate speed portions are highlighted between the two ones realised according to the principles of the present invention;
- figure 22 shows a schematic view of semiconductor package inherent the memory device of figure 2 wherein the main input/output pins are highlighted;
- figure 23 shows a more detailed schematic view of an embodiment of the fast matrix portion;
- figure 24 shows a schematic example of how an increase of conductivity of the elemental AND structures of the fast matrix portion is achieved by operating parallelisms of word lines on basis two or on basis four.

### Detailed description

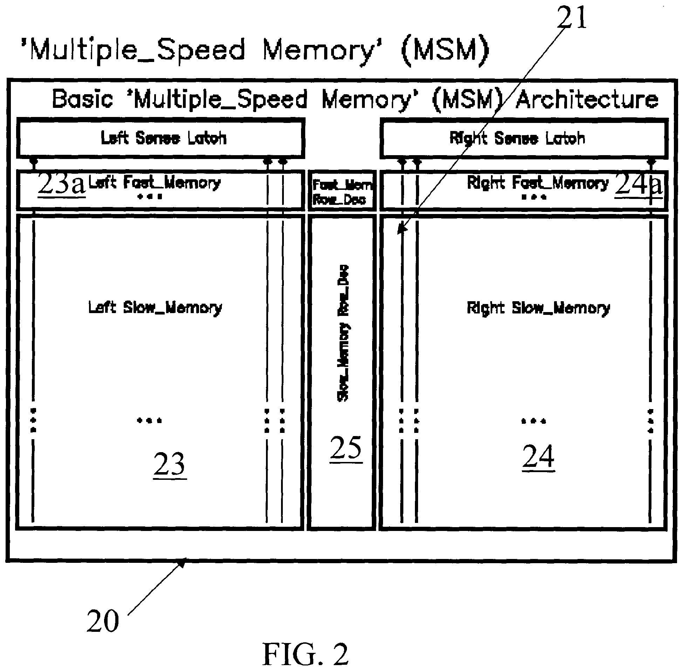

With reference to the figures, and in particular to the example of figure 2, a new memory electronic device realised according to the present invention and monolithically integrated on semiconductor is globally and schematically indicates at 20.

The device 20 incorporates at least one matrix 21 of memory cells organised in rows or word lines WL and columns or bit lines BL.

The device 20 is however a memory of the Flash EEPROM type with NAND architecture.

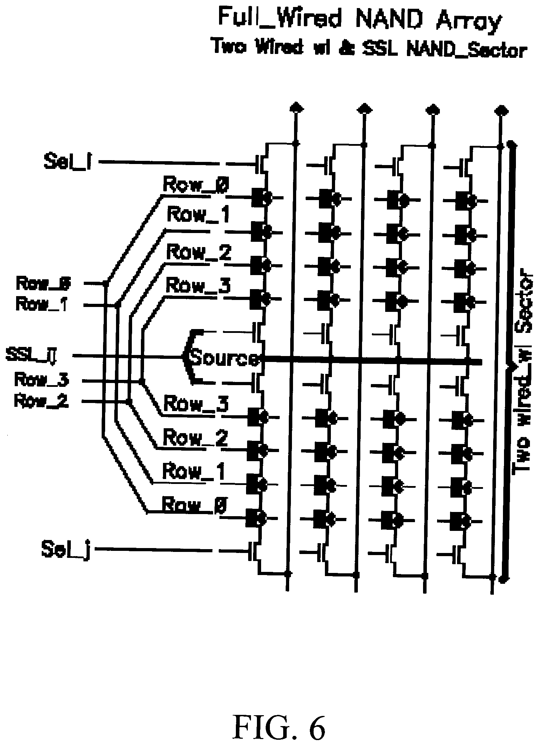

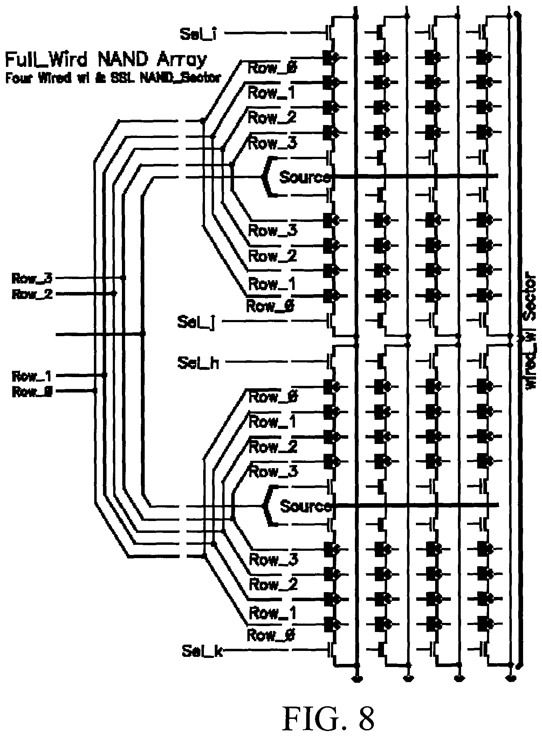

Figures 6 and 8 show instead two possible implementations of the array relative to the fast sections 23a and 24a of Flash EEPROM memory with NAND architecture of the device 20.

The invention allows, to the expense of a slight modification of the array of a NAND memory, to realise in a single chip, and thus with a single technology, a group of functions being typical of different memories and up to now obtained only by means of devices of different nature and structure.

In other words, the device 20 is realised on a single chip which integrates both the "hard disk" and boot ROM functions, avoiding the use of the assembly of several components coming from different technologies, even if arranged on a same package.

As already previously seen, figure 1 shows a schematic view of memory electronic device 1, in particular an EEPROM memory with NAND architecture realised according to the prior art. This type of architecture provides a very ordinate structure of memory cells divided into two sub-matrixes 3 and 4, left L and right R, referring to a single row decoding block 5 centrally arranged in the device 1.

Each one of the sub-matrixes 3 and 4 corresponds to a bank of registers of the read amplifiers or sense amplifiers 6 and 7.

It should be noted how both the Wl and the B1 are continuous and global lines, without any fragmentation.

Thanks to this particularly ordinate structure the area consume of the array is reduced and remarkable memory capacities can be easily obtained even of a 1Gigabit or up to a 2Gigabit and more.

With this advantage also different drawbacks are however associated:
- the Wl are very long: thus resistive, capacitively heavy and definitely slow to propagate the signal up to the array edges;
- the B1 are in turn very long, they collect a very high number of nodes which, summing an enormous capacity, create a load which causes extremely long times in the read transistors;
- the elemental structure of each sector exhibits a great number of devices in AND configuration (16, 32, as reported in fig. 26), which drastically reduces the conductivity and which, consequently, will not impose fast dynamics in the verify step.

According to the present invention a new architecture of NAND memory electronic device 20 is proposed wherein inside a same sub-matrix 23, 24, L or R, a smaller or however reduced sub-matrix portion 23a, 24a has been obtained, for example of 32Megabit or 64Megabit on global 1 Gigabit.

The consequence of this subdivision is the realisation of two portions whose bit lines BL have remarkably different sizes and capacitive weights, for example: short and light for the fast portion, long and heavy for the slow portion. The impact of this choice on the evaluation times will not be negligible at all.

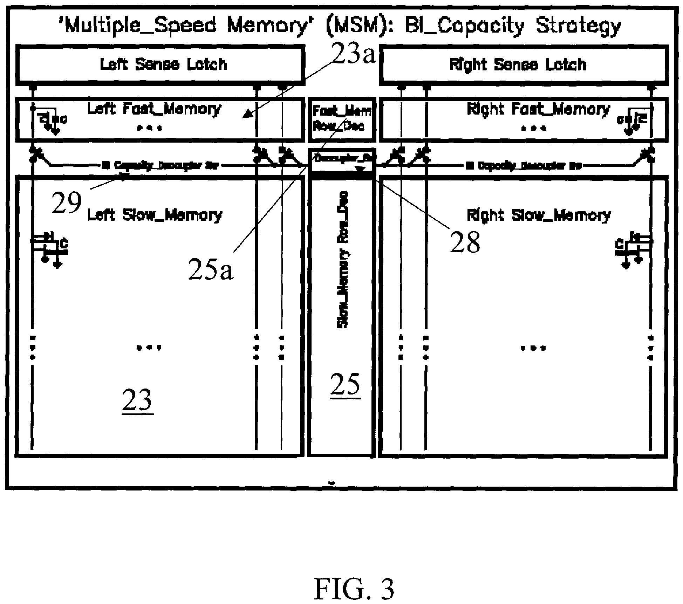

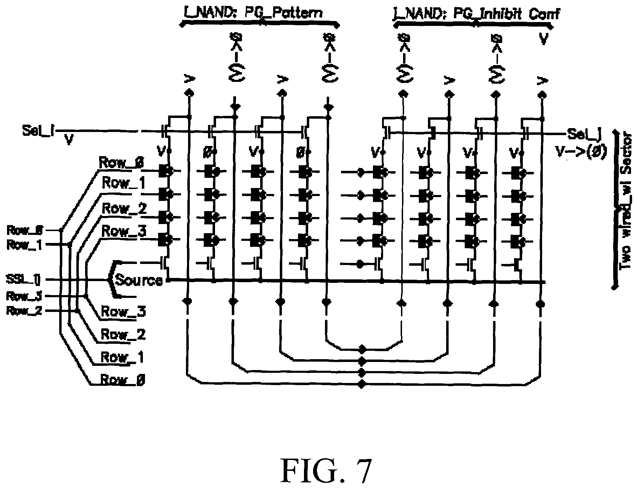

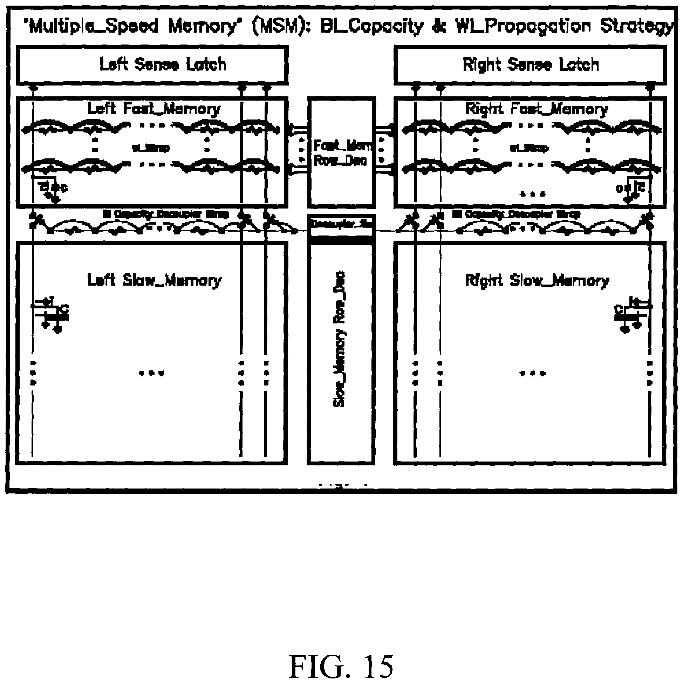

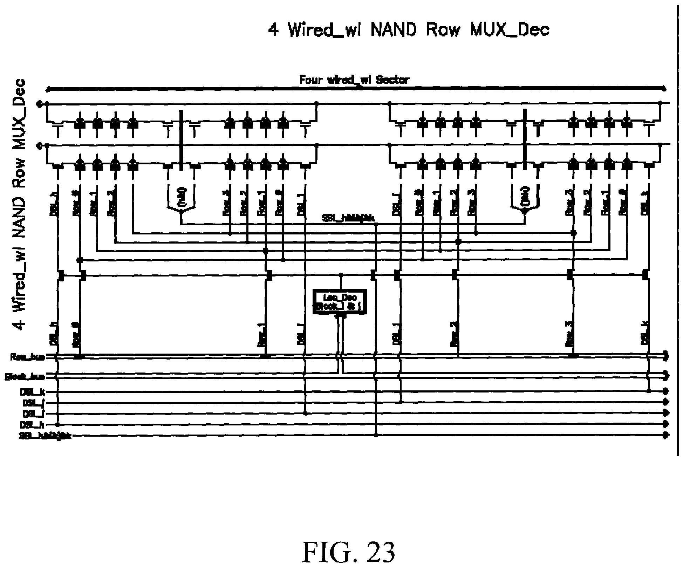

Moreover, such portion 23a or 24a, advantageously placed immediately close to the register and read structures is operative, thanks to suitable measures of array (figures 23, 6 and 7), of W1 features (fig. 15) and techniques for lightening of the load (fig. 3, 4, 15) at a definitely higher speed than the classical NANDs, i.e. with access times being comparable to the most performing architectures of the NOR type.

Hereinafter reference will be often made to only one of the two sub matrixes L, R, for example the one indicated with 23a, using for it the term matrix.

As it can be appreciated from the example of figure 2, the matrix portion 23a hereafter called "fast" is contiguous to a major matrix portion 23 called "slow", which is the higher part thereof with further connection function with the read & modify interfaces.

This peculiarity allows two important advantages to be achieved: it ensures size compatibility and continuity of the lines crossing the different matrix portions, and it allows a perfect "lightening" of the load for said fast portion with the really precious consequence of speeding up the pre-charge & verify operations.

It is important to remark that when we speak about size compatibility and continuity of the lines we mean that the two fast and slow sections exhibit the same number of B1 and that each B1 of the one is the continuation of the homonymous of the other being the portion B1 separated only by a device_switch 29, i.e. a pass transistor or a simple transistor switch.

The device_switch 29 has a fundamental function on the definition of the performances of the two portions.

In fact it provides to "capacitively decouple" the B1 of the fast portion (short and light) from the B1 of the slow portion (long and capacitively heavy) consequently facilitating the speed of the first portion 23a.

Therefore, in the present invention, any time one operates on the fast portion, said device_switch 29 is made 'OFF' with the aim of minimising the load and allowing the maximum speed thereof.

To the contrary, when one operates on the slow portion said device_switch is maintained 'ON' thus establishing the continuity between the B1 of the two sections and the readings which are started therein will have response times aligned to those of a conventional NAND_Flash

To the purposes of the present invention the fact that the MAIN Bit Lines can be interrupted is important, for example between a first and a second physical or logical sector adjacent to the column decoding.

The switch 29 decouples the capacitive loads of the MAIN Bil Line BL obtaining a functional separation of the main bit line.

A further measure which distinguishes the fast portion 23a and improves its performances is the adoption of "W1 strap techniques", which, widely described hereafter, allow the fundamental reduction of the propagation times of the selection signals.

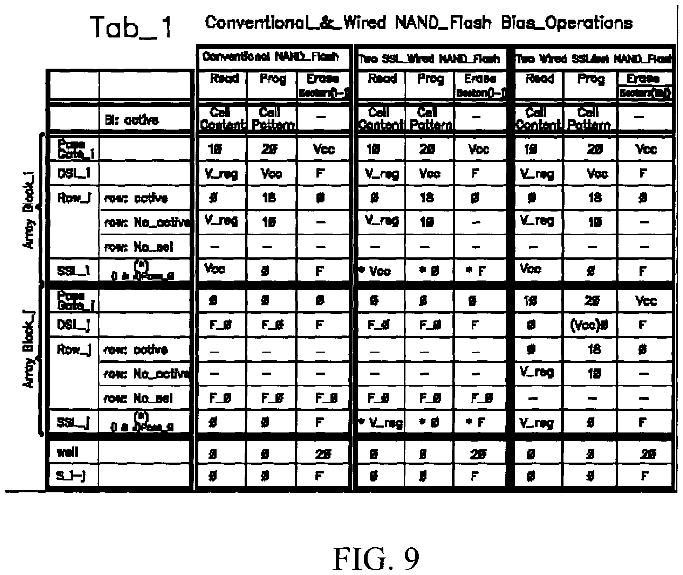

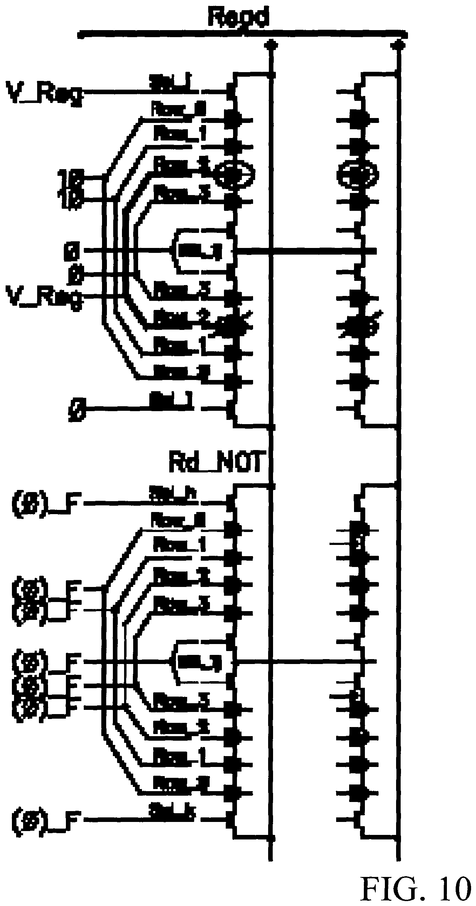

The feasibility of said improvement is made possible by the particular management of the W1 of the fast portion as reported by figures 6, 8, 14 together with the innovative operation modes shown in the figures 10, 11, 12, 13 and summarised in the table 1 of figure 9.

Advantageously the portion 23 is apt to the data storage and it comprises blocks being compatible with the features of a non volatile memory of the Flash type which, although slow, allows a remarkable reduction in the occupation of circuit area. In other words, the portion 23 is at high density of memory cells.

With the data storage portion 23 a corresponding row decoder 25 centrally arranged in the device 20 between the two sub-matrixes 23 and 24 is associated.

Similarly, with the code storage portion 23a a corresponding row decoder 25a centrally arranged in the device 20 between the two sub-matrixes 23a and 24a is associated.

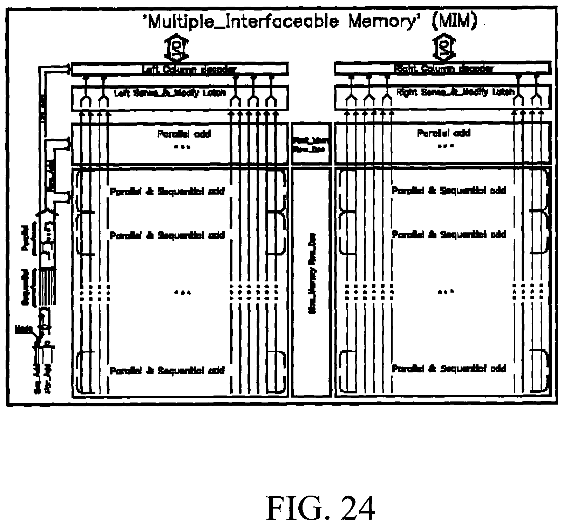

The cells with which the portion 23a of the *fast* type is constructed have the same electrical characteristics as those of the cells of the portion 23 of the "slow" type, i.e. they are programmed and erased according to identical modes, but they are organised in such a way as to operate with a higher read current. The conductivity increase of the elemental AND structures of the fast portion is advantageously obtained simply by reducing the number of the devices: four instead of 16 or 32 (figures 6, 8, 23) but it can be also thought in an alternative way operating parallelisms on basis 2 or on basis 4 as shown in fig. 24.

A great advantage deriving from the solution proposed by the present invention lies in the management of the different functions (Pg, Er, Rd) of the fast portion 23a shared with the slow portion 23.

This peculiarity has been developed on purpose so as to avoid additions and/or modifications to a traditional NAND architecture preserving the low current consume and high write/erase speed philosophy.

Summarising, the invention provides a new structure of a non volatile memory electronic device 20 being monolithically integrated on semiconductor and of the Flash EEPROM type with a NAND architecture, comprising at least one memory matrix 21 organised in rows and columns of memory cells but having the peculiarity that the matrix is divided into at least a first 23 and a second portions 23a having different data storage capacity and different access speed, although sharing the same bit lines structures.

The second matrix portion 23a is faster and it has lower sizes with respect to the first matrix portion 23.

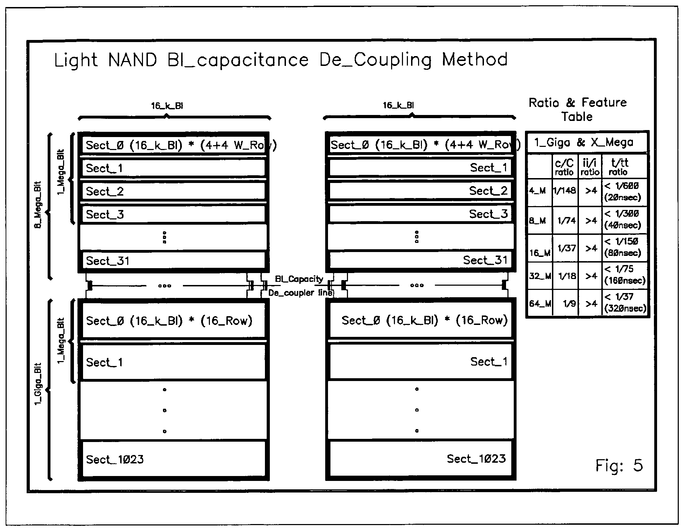

For example, the second portion 23a can be of 32Mbit or 64Mbit on global 1Gbit of the portion 23, as shown in figure 5.

Moreover, the second portion 23a operates with access times comparable to the NOR memory architectures, even if the cells with which the second portion 23a is constructed have the same electrical characteristics as those of the cells of the first portion 23.

In other words, the memory cells with which the second portion 23a is constructed are programmed and erased according to identical modes with respect to the cells of the first portion 23, but they are organised in such a way as to operate with a higher read current.

Advantageously, moreover, the second portion 23a comprises groups of only four cells in series with the relative selectors.

Current NAND memories do not allow to run an operative code, for example of the XIP type, since the random access time typical of these architectures is in the order of the 10-30usec.

The reason of such slowness is due to the particular organisation of the matrix which normally comprises groups of 32 cells in series which remarkably reduce its conductivity, connected with each other by means of long lines of selectors affected by remarkable slowness as regards the signal propagations.

Moreover, each physical sector (and they are an enormous number) refers, with its own elemental structure, to a generic B1 which therefore accumulates a considerable capacity value.

Such great capacity, combined with said very low conductivity of the elemental structures of a conventional NAND_Flash, causes very long verify times. The idea of a single B1, which collects the nodes of all the intersected sectors, perfectly responds to Bl compactness and minimisation criteria but it reveals to be disastrous and limiting for the dynamical aspect which results to be extremely slow.

The slowness is well tolerated for the applicative part relative to "Data Storage" activities; it is instead intolerable and it cannot be proposed where a quick response is needed, as required by applications of executive codes: "Data_Code".

Normally, the cell matrix is divided only into the two sub matrixes 3 and 4, L and R, shown in figure 1.

According to the present invention the portion 23a, which is limited in size and lightened of most the load, is fast and suitable to perform executive codes.

In fact, the cell matrix or sub matrix structured with the two slow 23 and fast 23a portions can be used for storing in these portions data of different type, for example a portion 23a can be intended for code storage activities and the other portion 23 can be intended to data storage activities.

The portion 23 being apt to the data storage has a size equal to 1Gbit and it follows the traditional organisation of the NAND cells with groups of sixteen/thirty-two cells with relative selectors and it can well tolerate a capacity of bit line of about ~5pF.

The portion 23a, being apt to code storage, can be instead of suitable size, according to the users' needs, a size from eight to 16Mbit seems to be enough for a program or system memory.

For example, figure 5 schematically shows the various logic sectors of the fast portion 23a with each sector made of eight rows (4+4 wired) and 16k columns for a total of thirty-two sectors suitable to form an 8Mbit memory per code storage. Whereas in the second portion 1024 sectors of 16 rows and 16k columns are shown for a total of 1Gbit of data storage.

However, nothing forbids to provide, for the portion 23a, a size of also 32Mbit or 64Mbit, obviously reducing the attainable performance.

Moreover, the bit line of this portion 23a although maintaining the direct connection with the underlying part is advantageously decoupled from the corresponding bit line of the portion 23 apt to the data storage (for this reason it is placed as terminal section) by means of pass transistors which will be hereafter called data bank selectors, but which do not expressively refer to the present invention.

The decoupling is activated any time a cell of the portion 23a is read (but it can also interest the modify operations).

The decoupling is actuated by placing the pass transistors 29 in the "OFF" state, for example by forcing a GND potential onto the bank selector line.

Where, instead, it should be operated on the slow part (first portion 23) the decoupling is prevented by maintaining the pass_transistors in the "ON" state, for example by forcing a logic value '1' always onto the bank selector line.

In this context the portion 23a acts as a communication bridge between the portion 23 and the read-modify registers: therefore configurations of B1 and verifications on the same occurs by means of the portion 23a.

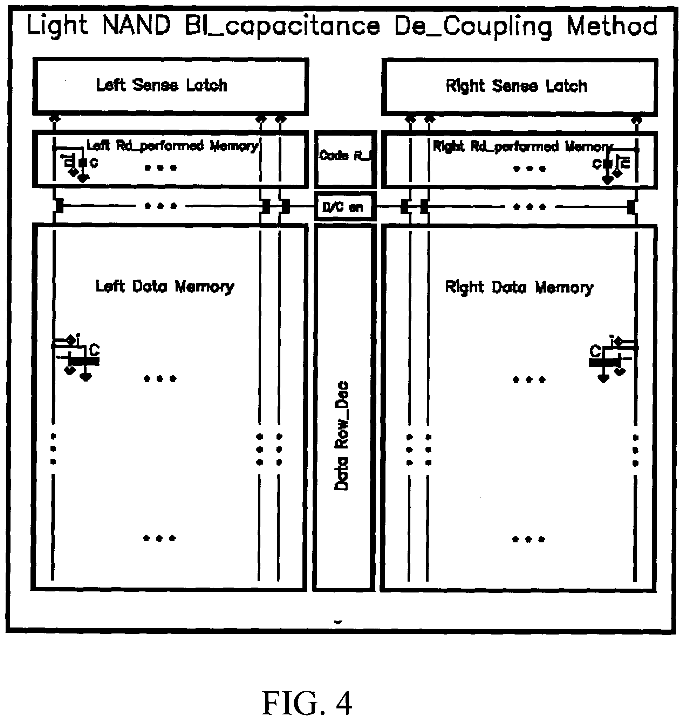

More in particular, as clearly shown in figure 4, the bit lines of the two memory matrix portions 23 and 23a, slow and fast, substantially have the same structure and they can be considered common to the two portions 23 and 23a.

However, the presence of a pass transistor 29 inserted onto the bit line in correspondence to the separation between the two matrix portions 23 and 23a allows to decouple a long capacity of bit lines and to obtain at least a matrix portion 23a with a bit line of lower extension. As per construction, therefore, the B1 is much less capacitive and therefore it can be, equally as any other parameter, much easily managed and realise faster dynamics.

The decoupling operation, absent in the conventional memories, can be admitted since it is not necessary for maintaining the functionality of the portion 23a to propagate the signal downstream of the same.

Advantageously, the various pass transistors 29, each inserted onto a corresponding bit line between the slow matrix portion 23 and the fast matrix portion 23a, are connected in parallel with each other and they refer to an enable block 28 centrally arranged in the device 20 between the two row decoders 25 and 25a.

In summary, the device 21 according to the invention is characterised in that the bit line of the second portion 23a is decoupled with respect to the corresponding bit line of the first portion 23 by means of pass transistors or bank selectors.

On the other hand, by decoupling the bit lines, the capacity of the bit line of the portion 23a, in the here described embodiment by way of indicative example of 32 and 64 Mbit, is reduced to a value equal to 1/32 and 1/16 with respect to the totality corresponding to the two portions 23 and 23a.

Preferably, as already said, such portion 23a comprises groups of only four cells in series with the relative selectors. The groups are organised with wired word lines as it will be shown hereafter in the description with reference to the figures from 6 to 13.

The reduction of the number of the transistors in series allows to remarkably increase the working current.

With this measure, and reasonably supposing an operation in linear zone, the current of the memory cells of the portion 23a increases until it surely reaches the theoretical value equal to at least eight times the current of the memory cells of the portion 23 apt to the data storage.

It should be noted that by means of a simple system of two equations with two unknown quantities it can be evinced that the discharge time of the portion 23a bit line which is equal to 1/256 or 1/128 of the discharge time of the bit line sum the two portions 23 and 23a.

Therefore, the access time, as regards the only B1, of the portion 23a is drastically reduced, even if not enough to take it again to a random access time typical of the memories used for running a software without the use of RAM (XIP Flash).

For reaching the aim of a reading with access times comparable with those of a Flash-NOR, in the memory fast portion 23a, the invention includes the implementation of "strapped" solutions both on the word-lines, and on the DSL (Drain Select-Line) and SSL (Source Select-Line) as it will be hereafter described with reference to figures from 14 to 20.

For this reason, the world lines have been managed in a wired mode since, thanks to this measure, the implementation is made possible of strap techniques which allow the remarkable reduction of the propagations indispensable for the attainment of the high performances. However, the wiring of the W1 is not immediately done, more than one problem having to be solved for maintaining both the functionality and the "unicity of information" for each cell: the proposed solutions for making the wiring possible will be described in greater detail hereafter in a dedicated section.

Obviously, the previous array sizing in the figure is reported only by way of example of the proposed idea and it does not exhaust all the possible combinations within the present invention.

In substance, the proposed architecture allows a user of the solid-state memory device to use it both as a data memory, and as a program and/or operative system memory.

This latter feature cannot be offered by current Flash NAND memories due to the high random access time (> 10usec).

As already previously highlighted, so far this lack has been obviated by using memories of the RAM type wherein the program code or operative system is stored at the start of any electronic device.

Further advantage is given by the fact that the proposed architecture allows a bank of erasable memory to be available with higher granularity, for example 4kB with respect to 32kB, since the fast memory portion 23a is organised with logic sectors having groups of only four plus four cells instead of thirty-two as it occurs for the slow portion 23.

For a better comprehension of the invention advantages, we hereafter report a series of features the new architecture of Flash NAND memory electronic device 21 allows to obtain:
a) a structure with at least two memory areas or portions with high speed difference;
b) the presence of a sub system with performances comparable with a data memory;
c) the presence of one or more memory portions with very fast random access and comparable with a memory of the NOR type;
d) the sharing of the functional structure for minimising the circuit area occupation;
e) the same word line length (even if with remarkably different propagation times) and, in the meantime the same number of bit lines;
f) the sizes equivalent to a memory specifically apt to the data storage function;
g) the features of a conventional data memory in terms of: protocol compatible with that of a conventional data memory and array efficiency (array/ die ratio) of a conventional data memory;
h) a number of masks employed in the manufacturing process of the integrated circuit equal to those typically employed for a process of the NAND type, with the advantage of employing a more easily reproducible technology with respect to a Flash NOR and therefore such as to ensure greater yield;
k) a lower silicon consume with respect to the solutions proposed by the known technique in terms of MCP;
l) a lower consume of current;
m) the possibility of programming the memory in the page mode with at least 512Byte.

This set of advantages is efficiently obtained thanks to the new NAND memory architecture which will be also defined of the Multi Speed type, as it will be clear from the following description.

According to a further aspect of the present invention, which will be now shown with reference to the figures 1A and from 6 to 13, the architecture of the NAND memory electronic device is described in detail according to the invention wherein inside the cell matrix the word lines are short-circuited in pairs and they are associated with a single source selector.

Obviously, the previous array sizing of figure 6 is reported only by way of example of the proposed solution and it does not exhaust all the possible combinations within the present invention.

According to the invention a selection of the matrix rows is thus provided so as to minimise the decoding network and facilitate the realisation of the memory device.

As it is well known, in the traditional architectures the word lines of a matrix are independent from each other and distinct from those of any other physical sector, i.e. the potential for selecting the cell to be read is applied to one and only matrix row.

On the contrary, according to the invention, in the memory device 21 each single sector, which will be hereafter defined "logic sector", incorporates groups of wired Wl obtained by short-circuiting with each other pairs of "homologous" Wl. Two and four are the most advantageous multiplicity of wiring contemplable but also harder multiplicities, of eight and more can be supposed.

For example, figure 6 shows a solution of a wiring of two word lines Wl wherein the first row of a physical sector has been short-circuited with the last row of an adjacent physical sector obtaining a logic sector which becomes for this architecture the smallest unit being entirely erasable.

Obviously, nothing forbids that this coupling can occur with different association modes between pairs of word lines. For example, the n-th row of a physical sector can be short-circuited with the n-th row of the adjacent physical sector, i.e. with the row having the same position within the adjacent physical sector.

It is thus understood how the possible coupling combinations are numerous.

Moreover, these examples are valid in the case wherein a multiple of two has been chosen for the coupling of the word lines of a given logic sector, thus with word lines coupled in pairs.

The association process can be extended to all the physical sectors and with the desired multiplicity.

It should be noted that in the architecture according to the invention only one sector SSL_ij of source line SL is provided for each pair of adjacent physical sectors, i.e. one single SSL for each logic sector. Whereas more drain selectors (DSL) are provided according to the implemented wiring multiplicity.

With this measure, as it will be hereafter made clearer, the single logic sector (which can be functionally defined as such) comprises all the groups having the wired Wl. In a conventional NAND memory the physical sector only includes an SSL, a DSL and the Wl belonging to the group defined by the two selection lines.

Thus, there is a fundamental difference between the definition of logic sector according to the present invention and the physical sector of a conventional matrix.

Consequence of this feature is that the sizes of the logic sectors between the two portions 23a and 23 can be different since the elemental structure of the same portions is different.

In particular, for low wiring multiplicity, for the fast portion (23a) there are logic sectors being smaller than the corresponding slow portion (for example: for a multiplicity 2 there is a sector size of 4+4 rows, against a size of 16/32 rows of the slow portion).

The portion 23a is characterised, generally, by smaller logic sectors: the granularity with respect to the erasing is thus higher and this is a further advantage of the present invention.

The unicity of the selection of a given cell is thus ensured by the drain selector, which must be maintained distinct for preserving the univocality of the row decoding operation, in figure 6 the presence of the upper drain selector SEL_i and lower SEL_J is to be noted.

With this technique the matrix rows are biased at least in pairs or in groups of four, eight etc... according to the multiplicity of association and grouping of the word lines.

Figure 8 schematically shows a wiring embodiment between four Wl which, in a conventional matrix, would interest four physical sectors and which have been instead incorporated according to the invention in a single logic sector having a single source select line SSL and four respective drain selectors.

It should be highlighted that the wiring between more Wl allows to reduce the number of the drivers necessary to stimulate the selection of the different selection lines. In fact, in a conventional Flash_NAND memory, taking into consideration a generic physical sector, as many selection networks are needed as many the W1 (16, 32, ...), SSL (1) and DSL (1)) are with the great difficulty of realising said networks in an area whose height is of a single elemental NAND structure.

This results in a highly suffered and disadvantageously cumbersome layout due to the very reduced available space.

The wiring, requiring, besides, a modification of the decoding network which will be described hereafter, allows to reduce both the complexity of the same and the number of the necessary networks themselves; not only: the available height for its execution is equal to the number of elemental structures recalled by the multiplicity of wiring (2, 4, 8). A very advantageous executive condition derives wherein simplified networks are implemented in generous spaces making relaxed layouts, distant from technologically difficult passages and, as a matter of fact, engaging definitely more reduced areas.

Obviously, the higher is the number of wiring of the word lines is the wider is the facilitation of the structures which interface the matrix.

In consequence, with this wiring method the criticality imposed by the smallest size of the row lines is completely eliminated which implies, as previously already said, a high number of interconnections and the fragmentation of the same decoding network.

According to the invention a row decoding is also provided suitable to manage a different organisation of the wired W1, so as to make it functional and at the same time to simplify its network and reduce its global number of transistors.

In fact, the typical one-to-one decoding scheme of the conventional NAND memories cannot be applied to the fast matrix portion 23a as that of figures 6 or 8 with word lines of the wired type.

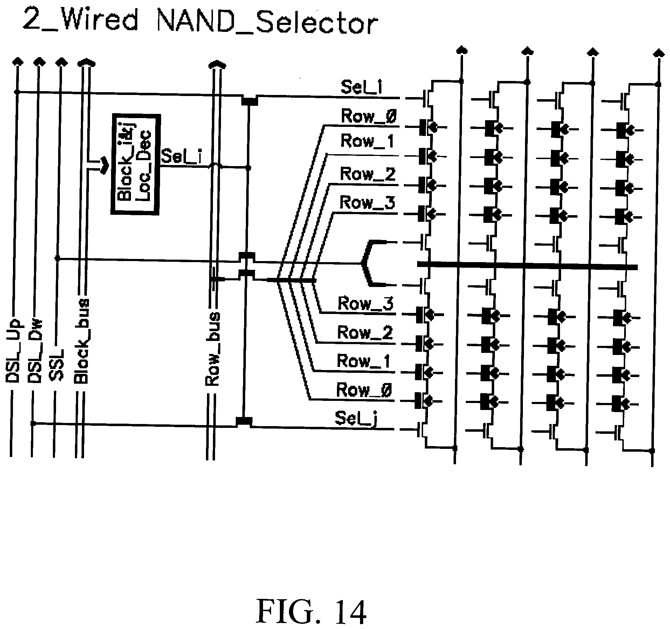

Figure 14 shows the update of the row decoding relative to the wiring of 2 Wl. As it can be observed the decoding scheme involves the lines of two elemental structure (two being the multiplicity of wiring considered), it lies on a single selection block (Block_i&j) which controls the enabling/disabling of the single management MUX of the sector predisposed for the stimulus of the Wl (4 lines), of the DSL (2 lines) and of the SSL (1 line). The inputs of the MUX are connected to the bus of the rows (4 lines) whereas the outputs are connected to as many pairs of wired Wl. Moreover, the same MUX controls the communication between the bus of the drain selection lines (DSL_Up & DSL_Dw, which are doubled in case of multiplicity four) and of the source selection line (SSL.) which instead is single no matter what the multiplicity is. More in detail the selection bus of the drain lines associates the DSL_Up with the selection of the elemental group i (Sel_i) whereas the DSL_Dw associates the selection of the elemental group j (Sel_j). The univocal solution of the block i&j is ensured by the control of the Block_bus.

The present scheme, compared to an analogue decoding of a conventional NAND, against two elemental structures, employs a single control block and a single MUX (2 blocks and 2 MUXs for the conventional one) with a considerable saving of devices (four transistors for the rows, only one for the SSL). The combination of this simplification with the double height due to the pair of interested elemental structures makes the greater realisation and area saving of the present invention evident.

Thus, in the end, the wiring of the Wl has inspired an advantageous simplification and a better implementation of the stimulus structures which however do not represent the only appreciable aspects of the invention. In fact, by enhancing the parallelism of the Wl and reducing the number of the SSL, the bases are thrown for a providential strap policy which brilliantly allows to reduce the signal propagations of the Wl and, thus, to complete that improvement of the parameters which control the reading dynamics.

The described wiring suitably increases the space wherein the by_pass connections can be produced with more conductive but, unfortunately, more cumbersome and critical layers allowing fast propagations. The possible strap solutions will be described in greater detail hereafter.

The novelties exposed up to now with reference to the present invention require a suitable theoretical support so that pragmatically the industrial feasibility thereof can be proposed.

In fact the novelties introduced have ended up by disrupting the traditional operating mode of a conventional Flash NAND memory.

In the first part of table 1 (TAB_1) of fig. 9 the biasing conditions of a conventional Flash NAND memory in its functional activities are reported in detail. Descriptively, such functions can be summarised as follows:
Reading: in the selected sector all the W1 are maintained at logic level '1' (V_read) except for the Wl which identifies the cell to be read which is maintained at logic level '0'. All the B1 Even or Odd are read thus reading a big page (from 512_bytes to 2k_bytes). The bank which is not object of the reading is forced to Gnd for eliminating effects (disturbs) of adjacency between Bl.
Erasing: in the selected sector all the Wl are forced to Gnd, the Bl are left floating whereas the well substrate is raised up to the erase voltage (20v). All the cells belonging to the sector made of a single stripe of NAND structures are erased.
Programming: in the selected sector all the W1 are biased to 10v whereas the W1 which identifies the cells to be programmed is subsequently raised up to the program voltage (18v); the pattern is forced onto the Bl: those which are forced to Gnd are programmed, those which remain high are not programmed; the programming involves the entire bank Even or Odd; the Bl of the bank being not object of the programming are forced to a high level for protecting them from the spurious programmings.

All the lines being of a generic logic sector managed in an univocal and independent way, no particular attentions have to be paid.

In the present invention some functional activities need suitable adaptations so that the operability is ensured even in presence of significant modifications produced in the array (wiring of the Wl, new structure of the sector). However, for the reading and the erasing the functions at issue maintain themselves identically. For the sole erasing it to be specified that, the sector involving a numerosity of elemental structures equal to the multiplicity of the wiring, the whole multiplicity of structures will be erased. It is good to recall the attention also on the reduced size of the logic sector according to the invention which, advantageously, allows to improve the erase granularity.

Figure 10 helps to understand what happens in the matrix according to the invention during the reading step of a cell content. Substantially the reading step can be performed as in a NAND memory of the traditional type.

In this case an adjusted voltage value V_reg is applied both to the drain selector of the portion interested in the reading and to the word lines of the cell to be read. The exclusion from the reading of the cell which is on the short-circuited word line is ensured by the low potential value (0 V) on the selector SEL_J pertaining to such short-circuited word line.

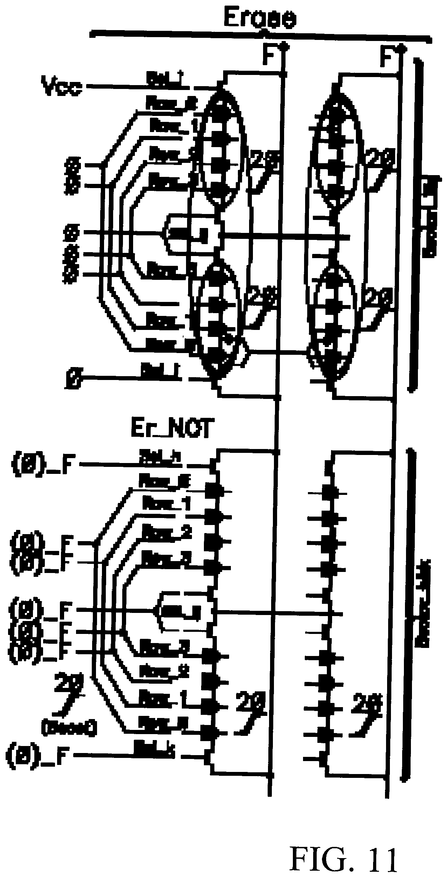

In a completely analogous way it is possible to graphically follow what occurs in the erasing step making reference to the example of figure 11.

In this case, as in the conventional approaches, it is possible to erase the cells content of an entire logic sector of the matrix by maintaining the potential floating on the bit lines and by applying a biasing voltage value equal to 0 V to all the word lines of the logic sector and by raising up the potential of the P-Well which physically contains the cells in the semiconductor substrate. The rows of the other logic sectors are instead maintained floating.

It is important to remember that in the architecture of the present invention a logic sector comprises all the cells in wiring and not only those belonging to a single physical sector of a NAND structure, as it occurs instead in conventional contexts. In other words, a logic sector involves two, four ... or other multiples on basis two packets or NAND physical sectors, in spite of a single packet.

The programming activity is instead more delicate. It is in fact known that the programming activity induces a remarkable amount of disturbs and cells which would not have to be modified are undesirably corrupted. The fields during the programming are high and where programming is not desired, the electrical stresses can be high and cause non desired variations.

For such reason, generally, the bank which is not object of the programming is pre-charged at a suitable voltage. Such measure, facilitating dynamics of 'auto_boosting' in the pre-charged structures allows to contain and limit the effects of the disturbs: the fields in fact with the auto_boosting are reduced and they downsize the efficiency of the disturbs.

The problem of the programming disturbs would be even more stressing in the present invention due to the plural selection of the word line which intercepts the cell to be programmed and to the need of excluding those which, although connected to the same word line, should not be programmed.

To such purpose, following the example of the normal programming, so as to prevent dangerous operative contexts, before proceeding to the real programming step, an program inhibit condition is to be set by activating all the DSL lines containing the word line interested in the programming and forcing a contextual pre-charging of all the NAND structures of the logic sector. In this way a configuration is obtained with inert conditions of the nodes which do not belong to the modify activity, as it will be clear hereafter.

In the second step all the DSL lines non associated with the packet containing the cell in the modify step are deselected and the pattern to be programmed is simultaneously configured by forcing a potential of 0 V on the bit lines BL of the cells to be programmed and leaving instead the pre-charging potential on the cells whose content is not to be modified. The programming of the entire logic sector provides as many modify activities as much the multiplicity of wiring of the logic sector and coordinate scan of the stimulation of the drain selection lines (DSL) are.

During the whole program operation the line SSL is maintained at 0 V so as to avoid any path towards ground.

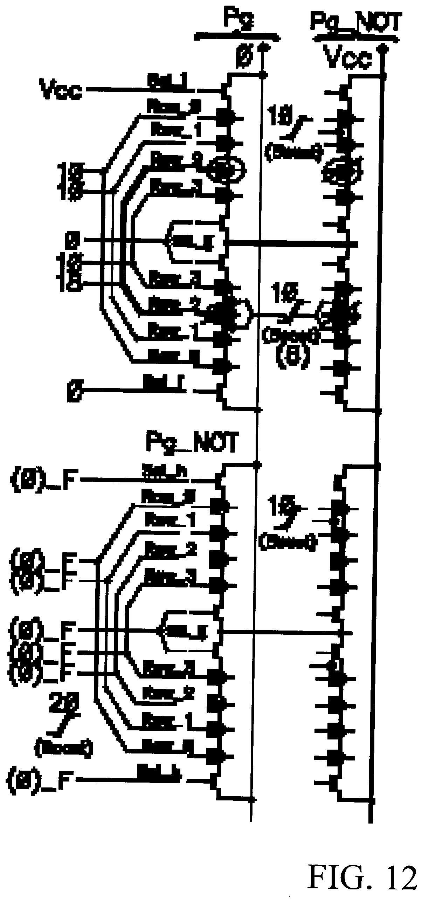

Making now reference to the example of figure 12, let's suppose that the cell to be programmed is in place on the second row ROW_2 and on the column or bit line interested in the program pulse Pg.

As well highlighted in figure 12, the program pulse provides a potential of 0 Volt on the bit line of the cell to be programmed, whereas the adjacent bit lines are interested in a biasing at the supply voltage Vcc which excludes the possibility of programming thereof.

Further to the structural modification provided by the present invention, two rows of the matrix logic sector are biased with the program voltage relatively high value (18 V).

However, the lower row associated with the row ROW_2 which is to be programmed is excluded simply by maintaining a potential of 0 V on the drain selector SEL_j of relevance. With this the relative intercepted and pre-charged sectors are left in the inhibit condition.

This occurs also for the selectors SEL_h and SEL_k of the logic sector which is not to be programmed.

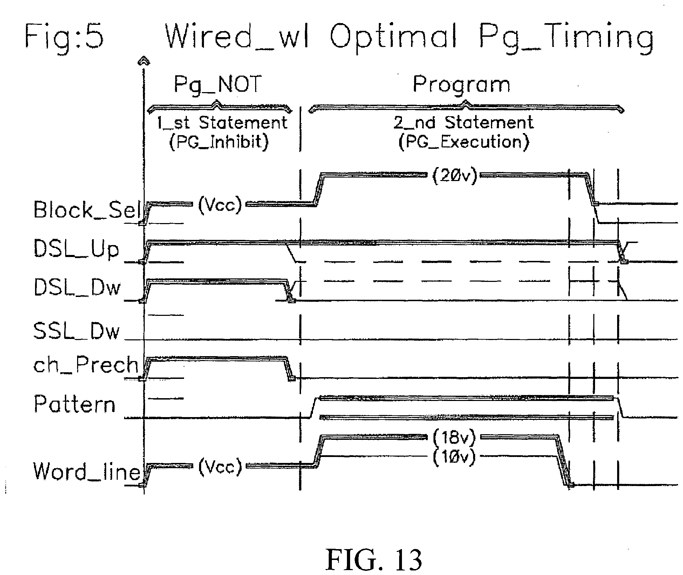

On the diagram of the timed signals of figure 13 it is worth noting that the real programming step occurs in two stages or two steps.

A first step provides the program inhibition with the drain selection signal raising up to the supply value Vcc both for the higher selector and for the lower one, and with the relative channel pre-charging.

At a second stage, the biasing of the upper selector is maintained at logic level '1' whereas that of the lower selector is brought to logic level '0' protecting the pre-charge of the underlying structure. Simultaneously the word line is enhanced at 18 V realising the real programming.

This fact allows to adjust the program timing so that in spite of the fact that the word lines are short-circuited the incidence of the disturbs are however limited.

The biasing values of the various nodes under the different operative conditions are collected in figure 9 in a comparative way with the conventional approach. In the same table of figure 9 also the management conditions relative to the wiring of the lines SSL only are shown.

Therefore, the present invention also relates to a programming method of the memory device 20 which provides that each programming step of one or more cells in parallel is preceded by an inhibition step of the programming obtained by activating all the drain selection lines DSL containing the word line or lines interested in the programming and forcing a simultaneous pre-charging of all the channels of the cells of a given logic sector.

A subsequent programming step provides to deselect all the drain selection lines DSL non associated with the packet containing the cell in the modify step.

Moreover, the pattern to be programmed is simultaneously configured by forcing a potential of 0 V on the bit line BL of the cells to be programmed maintaining the pre-charging potential on the channels of the cells whose content should not be modified.

Pairs of drain selectors are provided according to the multiplicity for each logic sector. Differently, only one control terminal is necessary for the different source selectors of a generic logic sector since the same, being wired, are simultaneously stimulated without causing misfunctions. Among the different stimulated source selectors only the one aligned with the selected drain will be active.

The source selector of a logic sector is distinct from the corresponding source selectors of other logic sectors.

With equal memory sizes, a logic sector of the matrix according to the invention corresponds to at least one pair of physical sectors of a matrix with NAND architecture of the traditional type.

With the architecture of the present invention the array is more easily retraceable and equally functional with respect to a traditional NAND architecture.

It is also important to note that for reducing the word line access time, which is one of the main parameters concurring to the read and program performance of the memory, it has been thought to implement a strap technique. Already used in other types of non volatile memory the strap would be an excellent solution for reducing the propagation times of the W1 but, at present, it is impossible to implement it in a conventional Flash NAND memory: the space available for technically performing it is too small.

In fact, a conventional NAND memory has the cells of so reduced sizes that only word lines are admitted having a minimum pitch being so small as to make the implementation of a technologically complex technique such as the strap physically impossible. For realising a strap, in fact, it is necessary to have sufficient spaces as to effect contacts and prepare by_pass paths with less resistive layers, such as metal. These latter are, however, technologically more cumbersome and they need wide 'passageways' for developing themselves: widely exceeding the pitch of the W1 (much more reduced) their implementation is substantially impossible.

Moreover, a conventional Flash NAND, has the peculiarity of having all independent control lines (Wl, DSL and SSL) whose high number would drag the same big number of shunts necessary to perform a strap. As a matter of fact the number further exasperates its difficulty. The combination of the two features (greater space of each line and high number of the same) is a insurmountable bastion towards any strap mode.

However, thanks to the introduction of the innovative method of the row selection, as previously shown in the descriptive part pertaining to the wired word lines, thus thanks to the possibility of simultaneously selecting two or more rows and the coordinate melting of the SSL in a single line, the implementation of the strap can be not only realised as shown in figure 15 but also leads to obtain word line propagation delays comparable, if not even lower than a traditional NOR architecture. Considering a wiring of multiplicity two, it has been said, that two elemental structures are involved each involving 4 cells NV. In this context, against a number of 12 necessary independent lines with a conventional management, only 7 (4_W1 +2_DSL +1_SSL) are needed with the wiring technique (fig. 6).

Similarly, considering a wiring of multiplicity four in place of the 24 conventional lines only 9 (4_WL +4_DSL +1_SSL) are needed (fig. 8), a remarkably lower number which frees a more than sufficient space for the execution of the strap. Therefore it has been possible to devise an advantageous strap technique by acting on three basic elements:
Incorporation of more elemental structures in a single sector;
wiring of all the homonymous lines of the elemental structures;
combination in a single selection line for the SSL for each logic sector.

The force of the three concepts, allowed by the new functional strategy, has been expressed, thus, in a great reduction of the number of independent lines necessary for the management of the single logic sectors. Therefore, the number of the shunt lines which make the strap is definitely downsized sanctioning the feasibility thereof without losing the minimal size of the cells (indispensable condition to maintain the greatest compactness of the memory).

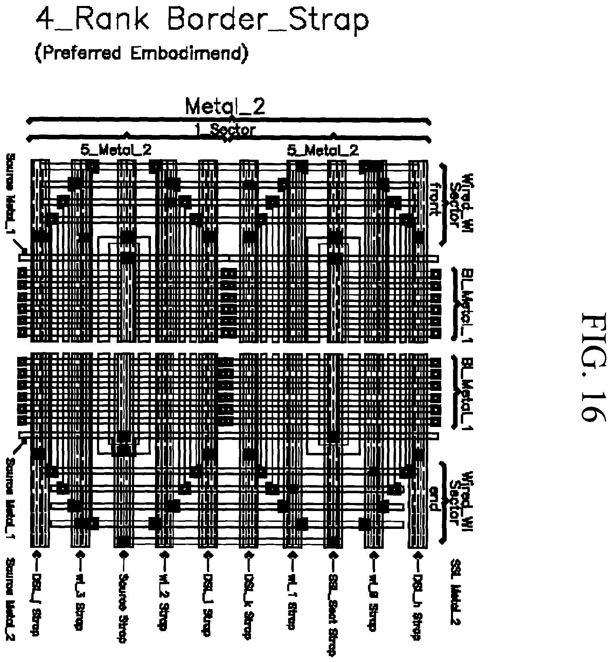

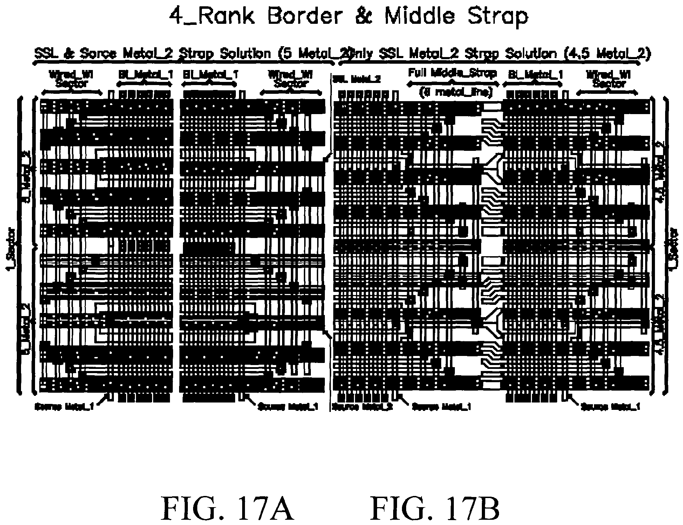

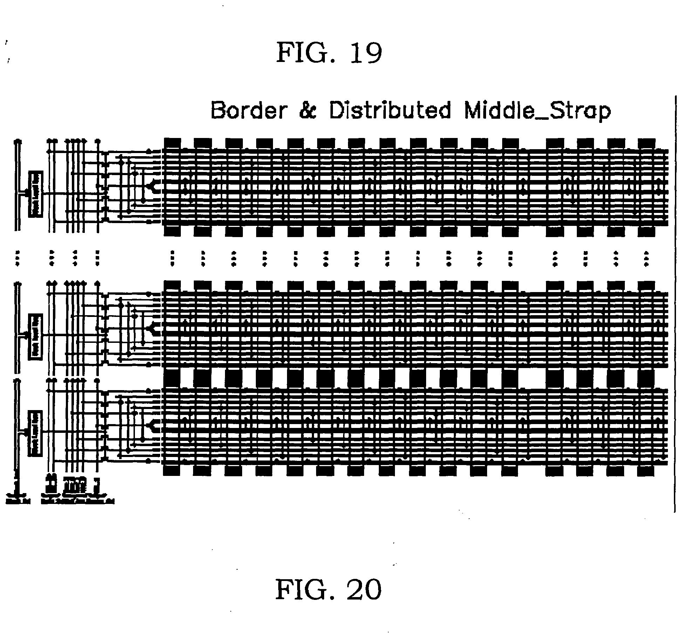

The orchestration of the three exposed concepts, which does not modify, as it has been seen, the functional features of the memory, has made the processing of the different strap typologies possible:
1. Border strap (example figures 16, 17A)
2. Full middle strap (example figures 17B, 18B, 20B)
3. Partial middle strap (example figure 20A)
4. Distributed middle strap (example figure 19)

Hereinafter the different types of straps are specified and shown in the annexed figures which make reference to the realisation of straps in sectors mainly having multiplicity of wiring 2 o 4;
'border_strap': it is an edge wiring characterised by strap contacts between homonymous lines carried out with 'scalar' technique; this in order to have the space necessary for their execution. The shorts between the homonymous lines are realised in metal_1 whereas the straps are realised in metal_2.

'Full middle strap' : it is a 'complete wiring" inside an array which realises the strap ensuring the continuity between homonymous lines of consecutive blocks. The shorts between the homonymous lines belonging to different elemental structures are realised in metal_1 whereas the straps are realised in metal_2 and the continuity between the lines of adjacent blocks is maintained via poly_2.

'Partial middle strap' is a middle strap limited to some lines, carried out in more different combinations: less cumbersome than the corresponding 'Full' it has the purpose of being transparent" as the occupied space inside the array.

Distributed middle strap' is the sum of all the 'partial middle straps' which, in succession and in a distributed way, realise one or more complete straps with the feature of a propagation at one fast and transparent as occupied space.

For each pair of blocks sharing the same drain contact common word-lines with relative shunts in metal 2 in the middle of each sub matrix are provided.

In substance, for pairs of matrix sectors sharing a same drain contact common word-lines are provided with relative metallisation shunts in the middle of each sub matrix.

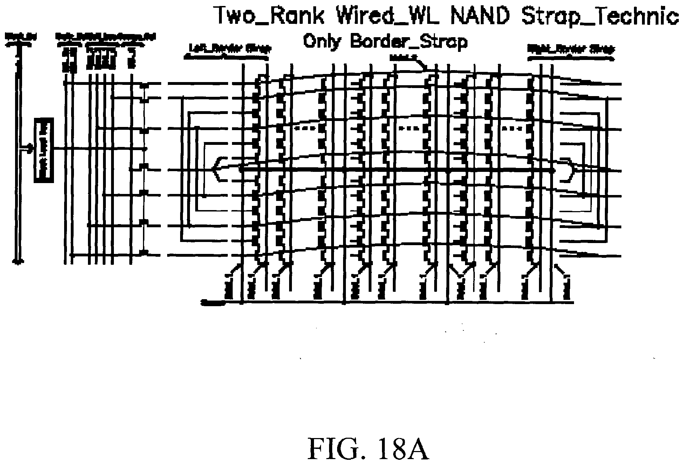

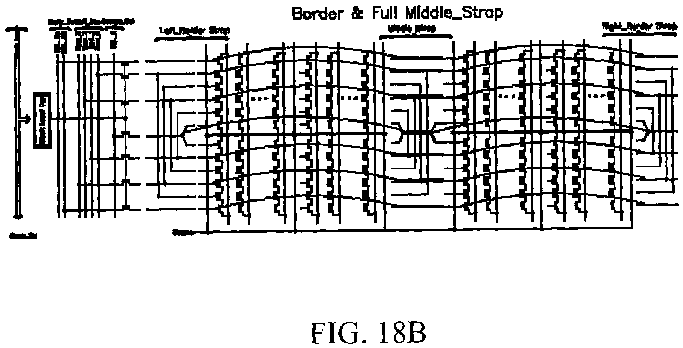

The same source SSL selectors are short-circuited, whereas the effective selection of the cell exclusively occurs by means of a drain selector, as shown for example in figure 18 in "full middle strap" mode.

As a general rule, one strap per sub matrix could be enough; however, analysing the structure of a typical NAND array more in detail it is observed that vertical ground lines in metal1 each 128 bit lines and vertical bias of P-well each 512 bit lines are provided.

In other words, vertical ground lines in metallisation of first level each 128 bit lines and vertical bias of P-well each 512 bit lines are provided.

Considering the great number of p-well bias existing in a typical NAND array, and thus the possibility of adding different strap points, the propagation times are so reduced as to be comparable if not even lower than those of a corresponding Flash NOR (i.e. < 20nsec). This solution is contemplated in the examples of figures 19 and 20.

A full strap would imply a greater space than the distributed strap and it would be advantageous only in the case wherein it is realised at the extremes, i.e. with the contacts at the edges of the device.

A distributed strap can instead be repeated more times at zero cost and it also allows a drastic reduction of the word line propagations.

The strap provided in the present invention is compatible with all the memory user mode operations, in particular the read and program steps are the same with respect to a structure without strap.

As regards instead the erase operation, the execution granularity of the same doubles with respect to the elemental structures since it is not possible to distinguish a structure inside a pair. This however does not penalise the memory general performances since it exclusively relates to the code portion which intimately has a higher granularity with respect to the data portion.

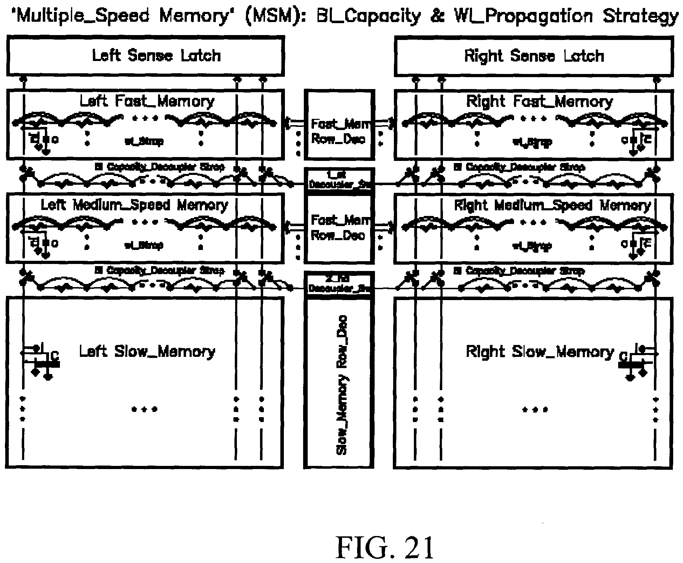

It is possible to further relax the pitch of the strap lines in metal2 by repeating the exposed method to two or more pairs of blocks, for example as shown in the figures 17A, 17B, 21 for the case of 2 pairs.

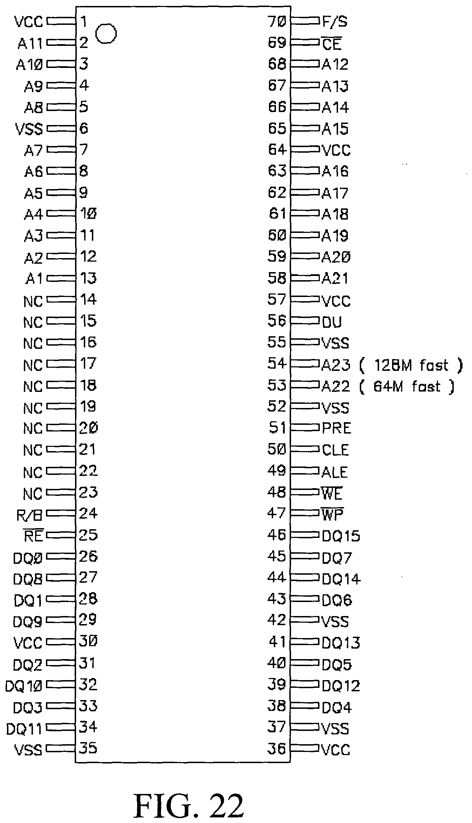

If, in this regard, it is to be highlighted that the described strap technique is easily applicable to the data memorisation portion (>= 16 cells, as shown in figures 22 and 23). Fig. 23, in fact, shows an advantageous realisation of border_strap which can be easily implemented at the matrix edges (but it could be thought also only at the 'front'): with this the propagation reduces to 1/4 of the traditional one. The contacting does not suffer from particular difficulties since, with scalar approach the swells of the contacts do not meet difficulties to be carried out and the strap lines are perfectly feasible: only 19 lines (16_row + 2_DSL + 1_SSL) in place of 36.

The access time of the code portion thus refers to a random access time typical of the memories used for running a software without the use of RAM (XIP Flash), i.e. <100nsec.

The here adopted solution allows to reduce in a significant way the word line delay partially responsible for the limited performances of the NAND architectures in reading.

Moreover, thanks to this measure the implementation of strap techniques is possible, such techniques allowing the remarkable reduction of the propagations indispensable for the attainment of the high performances.

Obviously, the previous example of array sizing in the figure is reported only by way of example of the proposed idea and it does not exhausts all the possible combinations within the present invention.

Among the other advantages offered by the wired word lines solution there is that of allowing the freeing of wide spaces for the implementation of the row decoding of a non volatile memory with sub-micrometric lithography, in particular it is especially suitable for use in NAND architectures, eliminating criticality or extreme fragmentations of the row decoding networks.

The principles of the present invention are easily extendible in the case wherein it is necessary to provide plural memory portions having different access speed and data storage capacity, all however being part of a same integrated electronic device.

For example figure 24 schematically shows how a device according to the invention can be organised with a slow matrix portion, a fast portion and an intermediate portion having speed in turn intermediate between the two preceding ones.

In this case, it is enough to provide two functional interruptions of the bit lines with interposition of relative pass transistors.

Advantageously, the portions 23 and 23a, respectively slow and fast, of the non volatile memory cell matrix 22, communicate with the respective interfaces by means of a communication protocol which manages the entire memory device 20 integrating the "hard disk" and boot/code ROM functions.

The device thus thought exhibits very different functional/performance aspects with respect to the products of the traditional flash_NAND type. In fact the new memory incorporates slow functional parts, other fast and both enhanced by further improvements which involve both flexibility aspects (addressing multiplicity), and of immediacy (possibility of random access both onto the entire memory and into any data array).

These new potentialities, for a better exaltation thereof, have suggested an enriched stimulus interface (Pin_Out), with respect to a traditional Flash_NAND, with a further address bus and a relative enable pin PA (paralle_Address). The new addressing structure adjacent to that typical of the traditional Flash_NAND has produced a new communication protocol.

Such protocol has been developed in such a way as to respect those features which optimise the performances of the device in terms of flexibility and compatibility, in particular:
# compatibility with the conventional NAND protocol for the read and modify operations (program and erase);
# random access of the NOR-like type for any sufficiently wide portion of the memory;
# speed in the refresh operations of the whole memory;
# binary number of the address pins;
# address register charged in a single clock pulse;
# invariance of the address system/bus with respect to the memory sizes;
# synchronous reading in the random mode;
# addressing mode of the "address bus free" type;
# switchings between the various operating modes of the "command free" type;
# control signals of the NAND protocol;
# a single control signal for switching between the various modes;
# the single non parallel read mode is by default the NAND one.

For completely exploiting the intrinsic potentialities of the architecture according to the invention a suitable reading method is to be defined which can be as much flexible as to pass from an operation mode to the other without resorting to burdensome and slow commands.

In this way the memory device 20 acts, for a processor with which it normally interacts, really as a single complex and integrated system of data, codes, information and base commands for the operative system storage.

The various memory portions 23, 24 and 23a, 24a have been thought and organised so as to be read indifferently with all the modes, obviously except for the different operation speed which depends instead on the matrix portion which is to be addressed.

The above mentioned features will be clearer from the following description.

By comparing the solution of the present invention with the known solutions, for example with the NAND memory of figure 1, it can be appreciated how such known memory device comprises a certain number (sixteen) of address pins and outputs (sixteen).

Both NAND architectures, for example: CL, AL, PR etc..., and NOR (W) architectures are also provided with traditional common control pins.

The addressing window equal to sixteen has been traditionally adopted for obtaining an efficient partitioning of the memory in terms of blocks, sectors and sub-sectors, and in such a way that the signals can move inside the memory with simple and "identifiable" loadings of the address registers respectively corresponding to the block, to the sector and to the selected sub-sector.

The memory device 20 according to the invention is capable of performances in reading of about ∼100nsec., which are typical of a NOR memory.

Moreover, such device 20 keeps the writing/erasing and, in general, modify performances of a typical NAND memory for data storage.

To meet these multiple needs a specific control pin has been provided, shown in figure 25 and indicated with the acronym PA, which allows to pass from a mode of the data storage type to a mode of the XIP type with a simple switch "0->1", or "1->0" in the opposed case.

All this without the need of using added clock and wait cycles of the microprocessor which interacts with the memory.

It is worth noting that the data storage mode makes use only of the traditional NAND protocol of the synchronous type and it is essentially addressed to the use of the memory as data/files storage.

In this case the control pin PA is kept at the logic level "0".

The device 20 can also however operate in the parallel access mode.

These modes are all referred to the device operation with the pin PA kept at the logic level "1".

Three main modes can be identified, whose wave forms relative to the signals applied to the device pins are reported in figure 26.

As it can be easily noted, the first two modes do not require any multiplexing of the addresses in the output pins, as instead occurs in the traditional NAND architectures.

The first one of these two protocols is of the asynchronous type and it essentially corresponds to a classical asynchronous protocol which allows to address up to 1Mbit of memory at a speed depending on the features of the selected array portion, for example 100nsec for the part of the NOR-like type and 20usec for the NAND part.

The second protocol is of the extended type and with the addition of a single clock pulse it allows to address up to 64Gbit by means of the loading of an address register with 32 bit in two successive instants (16 + 16), thus the reading of a generic datum at a speed depending on the array region wherein one is, for example 100nsec+clock for the NOR-like part, equivalent to ∼120nsec.

In both the first two protocols the outputs are free to switch in the state corresponding to the desired operation and/or cell.

A third protocol, called "maxi", makes use, by means of a multiplexing operation, of the output pins also used for the NAND protocol to address up to a maximum of 16Tbit.

In two successive instants the address m (middle) part and the address M part (most, with 8 bits) are respectively loaded by means of the address buffer and by means of the first output pins <0:7>, afterwards with a clock pulse on the pin AL the register 1 (least, with 16 bits) is loaded by means of the address pins and the reading is made start with a speed equal to that of the second protocol.

The third protocol is functionally distinguished from the first two exactly for the use of the pin AL which is intended for the definition of the latching operation of the addresses by means of the output pins.

Hereafter the main features of the reading step are summarised:
portion 23a NOR-like tacc: max 100nsec random, without limits; 30nsec burst & random (in page)
portion 23 NAND tacc: max 20usec random, without limits 30nsec burst & random (in page).

All the memory modify operations make use of the traditional protocol used in the NAND architectures and therefore they are not detailed in the description of the present invention.

Let's now consider an example of the operation of the device according to the invention.

Suppose that at the switching on step of a mobile electronic device (cellular, palmtop, camera, etc...) which incorporates the memory device according to the invention the content of a part IPL (Initial Program Loader) and of a second part SPL (Secondary Program Loader) of the mobile BIOS should be loaded in a first 1Mbit portion of the non volatile memory matrix object of the present invention.

Such first 1Mbit portion of program instructions have the peculiarity of allowing a quick access to the cells.

At the start up of the mobile device a reading of the memory is thus performed in the first 1Mbit locations (figure 5), since the address registers (32 or 40 according to the architecture) are: as regards the least part connected directly to the 16 external address pins, as for the middle (and most) parts to zero and reset by the power on reset signal.

The reading of these cells occurs at a speed of 100nsec.

The response speed of the device according of the invention is thus similar to that required by these boot operations and thus it does not need RAM loading.

In contrast to the most developed existing wireless memory devices, all the read operations performed with the protocol used in the present invention do not require additional commands such as, for example, the "load" of a RAM of normally smaller sizes than the smallest random addressable portion of the present invention (32Kbit with respect to 1Mbit).

Further important advantage of the described protocol is its flexibility, since it allows the memory reading both with a conventional approach of the NAND type and with an efficient random approach so as to speed up the responses of the fastest portions (portion 23a NOR-like, page buffer).

Moreover the passage from a mode to the other occurs without complicated wait cycles, but as function of a single control pin (PA) and it is thus immediate.

In conclusion, the memory device according to the present invention allows to realise, in a single chip, thus using a single technology, a group of functions up to now obtained only by associating memory chips realised and structured with different technologies.

Everything is obtained with a slight modification of the NAND memory matrix and it allows the use of a flash NAND structure, substantially substituting a RAM or a ROM, for the start up step.

From another point of view, the invention allows to make an intimately slow NAND structure with random access.

Globally the device and the method according to the present invention attain a rich series of advantages listed hereafter:
✔ Reduced costs and low circuit complexity;
✔ Memory areas (higher or equal to two) at different operative speeds, which can be selected by means of row decoding;
✔ Memory areas with at least a full random access part, substantially with NOR modes;
✔ A memory portion which can be used as data storage of greater capacity with respect to the portion apt to the code storage;
✔ NAND protocol for the sectors used for the data and full random access for the part apt to the code XIP ;
✔ It makes a RAM unnecessary to execute the code;
✔ Low assembling costs with respect to known solutions Toshiba/ Samsung;
✔ Low costs for the user in the case of use of extra chip RAM;
✔ Full technological compatibility with other associated NAND circuits, for example for the realisation of memory parts with NOR random access;
✔ Reduction of the capacitive weight of the bit lines by means of decouplers;
✔ Continuity and sharing of the structures of the NAND areas at different speed.

## Claims

1. A non-volatile memory (20) integrated on a semiconductor, the non-volatile memory being of the flash EEPROM type, the non-volatile memory comprising:
a memory matrix (21) being divided into physical sectors and organised in rows and columns of flash memory cells;
the memory_matrix (21) being divided into at least a first (23) and a second physical memory portion (23a) of flash memory cells, said at least first (23) and second physical memory portions (23a) share the structures of the columns, said first (23) and second (23a) physical portions having different minimum erasable sector sizes and different data storage capacities, wherein the structures of columns belonging respectively to said first (23) and second memory portions (23a) have the same numerosity; and
a decoupling switch (29) to capacitively decouple the first (23) and second (23a) physical portions, **characterized in that**
the non-volatile memory is of NAND architecture;
said first (23) and second (23a) physical portions have different column capacitances and different access speeds due to the different column capacitances;
each column of the first portion (23) is the continuation of the homonymous column of the second portion (23a) wherein each column of the first portion has a different length than the continuation of the homonymous column of the second portion causing the different column capacitances;
at least one row of a given physical sector is electrically connected to at least one row of an adjacent physical sector to form a single logic sector, the electrically connected rows are coupled in groups of two or multiples of two, wherein source terminals of corresponding cells of the connected rows coupled in groups of two or multiples of two referring to a same selection line (SSL) of a source line.

2. The non-volatile memory according to claim 1, wherein the n-th row of a physical sector is coupled with the n-th row of the adjacent physical sector, the coupled rows having the same position in the respective physical sectors.

3. The non-volatile memory according to claim 1, wherein the source terminals of the corresponding memory cells of the connected rows pair referring to the same selection line (SSL) of source line and wherein at least a same matrix logic sector comprises pairs of rows coupled with the rows of each pair placed on opposite parts with respect to said selection line (SSL) of source line.

4. The non-volatile memory according to claim 1, wherein in each logic sector a number of independent drain selectors equal to the number of physical sectors associated with only one and dedicated selection line (SSL) of source line corresponds to each group of coupled rows.

5. The non-volatile memory according to claim 1, wherein the cells of the coupled rows are biased in parallel on the respective gate terminal and wherein at least one selector of each column is provided to bias the drain terminal of a memory cell belonging to one or to the other of the coupled rows.

6. The non-volatile memory according to claim 1, wherein a column of the logic sector includes a number of elemental structures equal to a number of coupled rows having all the same selection line (SSL) of source line, each elemental structure having a dedicated drain selection line (DSL).

7. The non-volatile memory according to claim 1, wherein said first portion (23) is at lower access speed, and the rows of said first portion (23) are electrically independent from one another.

8. The non-volatile memory according to claim 1, further comprising modify and read structure; and wherein each of said first (23) and second memory portions (23a) comprises reading and programming circuit portions shared with one another respectively, the second memory portion (23a) is placed close to the modify and read structures.

9. The non-volatile memory according to claim 1, wherein the structures of columns belonging respectively to said first (23) and second memory portions (23a) have the same numerosity of elemental structures.

10. The non-volatile memory according to claim 9, wherein the elemental structures of columns belonging respectively to said first (23) and second memory portions (23a) have different sizes and capacitances and they are separated only by electrical decoupling controlled switches (29), said electrical decoupling switches comprising at least one of transistors or bank selector.

11. The non-volatile memory according to claim 1, wherein the memory cells constructing said second portion (23a) have the same electrical characteristics of the memory cells as those of said first portion (23), wherein they are programmed and erased according to identical modes and the memory cells of said second physical portion (23a) are organised so as to operate with a greater reading current than the respective memory cells of said first physical portion (23).

12. The non-volatile memory according to claim 6, wherein said elemental structure comprises, in the most conductive configuration, groups of four memory cells in series with the corresponding selectors.

13. The non-volatile memory according to claim 6, wherein said rows are coupled by means of tracks of first metallisation level and metallisation shunts are provided, equal to the number of the pairs of word lines (WL) referring to a metallisation track of second metallisation level.

14. A method for operating a non-volatile memory according to claim 1, the method comprising the steps of:
short-circuiting said at least first physical portion (23) to said second physical portion (23a), and
capacitively decoupling the first (23) and second (23a) physical portions using a decoupling switch (29).

15. The method of claim 14, wherein the n-th row of a physical sector is coupled with the n-th row of the adjacent physical sector, the coupled rows having the same position in the respective physical sectors.

16. The method of claim 14, wherein the source terminals of the corresponding memory cells of the connected rows pair referring to a same selection line (SSL) of source line and wherein at least a same matrix logic sector comprises pairs of rows coupled with the rows of each pair placed on opposite parts with respect to said selection line (SSL) of source line.

## Patentansprüche

1. Nichtflüchtiger Speicher (20), der auf einem Halbleiter integriert ist, wobei der nichtflüchtige Speicher von dem Flash-EEPROM-Typ ist, wobei der nichtflüchtige Speicher Folgendes umfasst:
eine Speichermatrix (21), die in physische Sektoren unterteilt ist und in Zeilen und Spalten von Flash-Speicherzellen organsiert ist;
wobei die Speichermatrix (21) in wenigstens einen ersten (23) und einen zweiten physischen Speicherteil (23a) von Flash-Speicherzellen unterteilt ist, wobei der wenigstens erste (23) und zweite physische Speicherteil (23a) die Strukturen der Spalten teilen, wobei der erste (23) und zweite (23a) physische Teil unterschiedliche minimale löschbare Sektorgrößen und unterschiedliche Datenspeicherkapazitäten aufweisen, wobei die Strukturen aus Spalten, die zu dem ersten (23) bzw. zweiten Speicherteil (23a) gehören, die gleiche Vielzähligkeit aufweisen; und
einen Entkopplungsschalter (29) zum kapazitiven Entkoppeln des ersten (23) und zweiten (23a) physischen Teils, **dadurch gekennzeichnet, dass**
der nichtflüchtige Speicher eine NAND-Architektur aufweist;
der erste (23) und zweite (23a) physische Teil unterschiedliche Spaltenkapazitäten und unterschiedliche Zugriffsgeschwindigkeiten aufgrund der unterschiedlichen Spaltenkapazitäten aufweisen;
jede Spalte des ersten Teils (23) die Fortsetzung der homonymen Spalte des zweiten Teils (23a) ist, wobei jede Spalte des ersten Teils eine andere Länge als die Fortsetzung der homonymen Spalte des zweiten Teils aufweist, wodurch die unterschiedlichen Spaltenkapazitäten hervorgerufen werden;
wenigstens eine Zeile eines gegebenen physischen Sektors elektrisch mit wenigstens einer Zeile eines angrenzenden physischen Sektors verbunden ist, um einen einzigen logischen Sektor zu bilden, wobei die elektrisch verbundenen Zeilen in Gruppen von zwei oder Vielfachen von zwei gekoppelt sind, wobei Sourceanschlüsse entsprechender Zellen der verbundenen Zeilen, die in Gruppen von zwei oder Vielfachen von zwei gekoppelt sind, auf eine gleiche Selektionsleitung (SSL) einer Sourceleitung verweisen.

2. Nichtflüchtiger Speicher nach Anspruch 1, wobei die n-te Zeile eines physischen Sektors mit der n-ten Zeile des angrenzenden physischen Sektors gekoppelt ist, wobei die gekoppelten Zeilen die gleiche Position in den jeweiligen physischen Sektoren haben.

3. Nichtflüchtiger Speicher nach Anspruch 1, wobei die Sourceanschlüsse der entsprechenden Speicherzellen der verbundenen Zeilenpaare auf die gleiche Selektionsleitung (SSL) der Sourceleitung verweisen und wobei wenigstens ein gleicher Matrixlogiksektor Paare von Zeilen umfasst, die mit den Zeilen jedes Paares gekoppelt sind, die auf entgegengesetzten Teilen mit Bezug auf die Selektionsleitung (SSL) der Sourceleitung platziert sind.

4. Nichtflüchtiger Speicher nach Anspruch 1, wobei in jedem logischen Sektor eine Anzahl an unabhängigen Drainselektoren, gleich der Anzahl an physischen Sektoren, die mit nur einer und dedizierten Selektionsleitung (SSL) einer Sourceleitung assoziiert sind, jeder Gruppe gekoppelter Zeilen entsprechen.

5. Nichtflüchtiger Speicher nach Anspruch 1, wobei die Zellen der gekoppelten Zeilen parallel auf den jeweiligen Gateanschluss vorgespannt sind und wobei wenigstens ein Selektor jeder Spalte bereitgestellt ist, um den Drainanschluss einer Speicherzelle, die zu einer oder der anderen der gekoppelten Zeilen gehört, vorzuspannen.

6. Nichtflüchtiger Speicher nach Anspruch 1, wobei eine Spalte des logischen Sektors eine Anzahl an Elementstrukturen gleich einer Anzahl an gekoppelten Zeilen beinhaltet, die alle die gleiche Selektionsleitung (SSL) der Sourceleitung aufweisen, wobei jede Elementstruktur eine dedizierte Drainselektionsleitung (DSL) aufweist.

7. Nichtflüchtiger Speicher nach Anspruch 1, wobei der erste Teil (23) eine niedrigere Zugriffsgeschwindigkeit aufweist und die Zeilen des ersten Teils (23) elektrisch unabhängig voneinander sind.

8. Nichtflüchtiger Speicher nach Anspruch 1, der ferner eine Modifizierung-und-Lese-Struktur umfasst; und wobei sowohl der erste (23) als auch der zweite Speicherteil (23a) jeweils Lese-und-Programmier-Schaltkreisteile umfassen, die miteinander geteilt werden, wobei der zweite Speicherteil (23a) nahe den Modifizierung-und-Lese-Strukturen platziert ist.

9. Nichtflüchtiger Speicher nach Anspruch 1, wobei die Strukturen von Spalten, die jeweils zu dem ersten (23) und zweiten Speicherteil (23a) gehören, die gleiche Vielzähligkeit an Elementstrukturen aufweisen.

10. Nichtflüchtiger Speicher nach Anspruch 9, wobei die Elementstrukturen von Spalten, die jeweils zu dem ersten (23) und zweiten Speicherteil (23a) gehören, unterschiedliche Größen und Kapazitäten aufweisen und sie nur durch gesteuerte elektrische Entkopplungsschalter (29) getrennt werden, wobei die elektrischen Entkopplungsschalter Transistoren und/oder einen Bankselektor umfassen.

11. Nichtflüchtiger Speicher nach Anspruch 1, wobei die Speicherzellen, die den zweiten Teil (23a) bilden, die gleichen elektrischen Charakteristiken der Speicherzellen wie jene des ersten Teils (23) aufweisen, wobei sie gemäß identischen Modi programmiert und gelöscht werden und die Speicherzellen des zweiten physischen Teils (23a) so organisiert sind, dass sie mit einem größeren Lesestrom als die jeweiligen Speicherzellen des ersten physischen Teils (23) arbeiten.

12. Nichtflüchtiger Speicher nach Anspruch 6, wobei die Elementstruktur in der leitfähigsten Konfiguration Gruppen aus vier Speicherzellen in Serie mit den entsprechenden Selektoren umfasst.

13. Nichtflüchtiger Speicher nach Anspruch 6, wobei die Zeilen mittels Bahnen einer ersten Metallisierungsebene gekoppelt sind und Metallisierung-Shunts gleich der Anzahl an Paaren von Wortleitungen (WL), die auf eine Metallisierungsbahn einer zweiten Metallisierungsebene verweisen, bereitgestellt sind.

14. Verfahren zum Betreiben eines nichtflüchtigen Speichers nach Anspruch 1, wobei das Verfahren die folgenden Schritte umfasst:
Kurzschließen des wenigstens ersten physischen Teils (23) mit dem zweiten physischen Teil (23a), und kapazitives Entkoppeln des ersten (23) und zweiten (23a) physischen Teils unter Verwendung eines Entkopplungsschalters (29).

15. Verfahren nach Anspruch 14, wobei die n-te Zeile eines physischen Sektors mit der n-ten Zeile des angrenzenden physischen Sektors gekoppelt wird, wobei die gekoppelten Zeilen die gleiche Position in den jeweiligen physischen Sektoren aufweisen.

16. Verfahren nach Anspruch 14, wobei die Sourceanschlüsse der entsprechenden Speicherzellen des verbundenen Zeilenpaars auf eine gleiche Selektionsleitung (SSL) einer Sourceleitung verweisen und wobei wenigstens ein gleicher Matrixlogiksektor Paare von Zeilen umfasst, die mit den Zeilen von jedem Paar gekoppelt sind, das auf entgegengesetzten Teilen mit Bezug auf die Selektionsleitung (SSL) der Sourceleitung platziert ist.

## Revendications

1. Mémoire non volatile (20) intégrée sur un semiconducteur, la mémoire non volatile étant du type EEPROM Flash, la mémoire non volatile comportant :
une matrice (21) de mémoire qui est divisée en secteurs physiques et organisée en lignes et en colonnes de cellules de mémoire Flash ;
la matrice (21) de mémoire étant divisée en au moins une première (23) et une deuxième partie (23a) de mémoire physique de cellules de mémoire Flash, lesdites première (23) et deuxième (23a) parties au moins de mémoire physique partageant les structures des colonnes, lesdites première (23) et deuxième (23a) parties physiques présentant des tailles minimales de secteurs effaçables différentes et des capacités différentes de stockage de données, les structures de colonnes qui appartiennent respectivement auxdites première (23) et deuxième (23a) parties de mémoire présentant la même multiplicité ; et
un commutateur (29) de découplage servant à découpler de façon capacitive les première (23) et deuxième (23a) parties physiques, **caractérisé en ce que** la mémoire non volatile est d'architecture NON ET ;
lesdites première (23) et deuxième (23a) parties physiques présentent des capacitances de colonnes différentes et vitesses d'accès différentes dues aux capacitances de colonnes différentes ;
chaque colonne de la première partie (23) est la continuation de la colonne homonyme de la deuxième partie (23a), chaque colonne de la première partie présentant une longueur différente de celle de la continuation de la colonne homonyme de la deuxième partie, ce qui cause les capacitances de colonnes différentes ;
au moins une ligne d'un secteur physique donné est reliée électriquement à au moins une ligne d'un secteur physique adjacent pour former un seul secteur logique, les lignes reliées électriquement sont couplées par groupes de deux ou multiples de deux, des bornes de source de cellules correspondantes des lignes reliées couplées par groupes de deux ou multiples de deux se référant à une même ligne de sélection (SSL) d'une ligne de source.

2. Mémoire non volatile selon la revendication 1, la nième ligne d'un secteur physique étant couplée avec la nième ligne du secteur physique adjacent, les lignes couplées occupant la même position dans les secteurs physiques respectifs.

3. Mémoire non volatile selon la revendication 1, les bornes de source des cellules de mémoire correspondantes de la paire de lignes reliées se référant à la même ligne de sélection (SSL) de ligne de source et au moins un même secteur logique de matrice comportant des paires de lignes couplées avec les lignes de chaque paire placées sur des parties opposées par rapport à ladite ligne de sélection (SSL) de ligne de source.

4. Mémoire non volatile selon la revendication 1, **caractérisée en ce que**, dans chaque secteur logique, un nombre de sélecteurs de drain indépendants égal au nombre de secteurs physiques associés à une ligne de sélection (SSL) unique et dédiée de ligne de source correspond à chaque groupe de lignes couplées.

5. Mémoire non volatile selon la revendication 1, les cellules des lignes couplées étant polarisées en parallèle sur la borne de grille respective et au moins un sélecteur de chaque colonne étant prévu pour polariser la borne de drain d'une cellule de mémoire appartenant à l'une ou à l'autre des lignes couplées.

6. Mémoire non volatile selon la revendication 1, une colonne du secteur logique comprenant un nombre de structures élémentaires égal à un nombre de lignes couplées possédant toutes la même ligne de sélection (SSL) de ligne de source, chaque structure élémentaire possédant une ligne dédiée de sélection de drain (DSL).

7. Mémoire non volatile selon la revendication 1, ladite première partie (23) étant à plus basse vitesse d'accès, et les lignes de ladite première partie (23) étant électriquement indépendantes les unes des autres.

8. Mémoire non volatile selon la revendication 1, comportant en outre une structure de modification et de lecture ; et chacune desdites première (23) et deuxième (23a) parties de mémoire comportant des parties de circuit de lecture et de programmation partagées respectivement entre elles, la deuxième partie (23a) de mémoire étant placée près des structures de modification et de lecture.

9. Mémoire non volatile selon la revendication 1, les structures de colonnes qui appartiennent respectivement auxdites première (23) et deuxième (23a) parties de mémoire présentant la même multiplicité de structures élémentaires.

10. Mémoire non volatile selon la revendication 9, les structures élémentaires de colonnes qui appartiennent respectivement auxdites première (23) et deuxième (23a) parties de mémoire présentant des tailles et des capacitances différentes et celles-ci n'étant séparées que par des commutateurs commandés (29) de découplage électrique, lesdits commutateurs de découplage électrique comportant des transistors et/ou un sélecteur de bloc.

11. Mémoire non volatile selon la revendication 1, les cellules de mémoire qui constituent ladite deuxième partie (23a) présentant les mêmes caractéristiques électriques des cellules de mémoire que celles de ladite première partie (23), celles-ci étant programmées et effacées selon des modes identiques et les cellules de mémoire de ladite deuxième partie physique (23a) étant organisées de façon à fonctionner avec un courant de lecture plus important que les cellules de mémoire respectives de ladite première partie physique (23).

12. Mémoire non volatile selon la revendication 6, ladite structure élémentaire comportant, dans la configuration la plus conductrice, des groupes de quatre cellules de mémoire en série avec les sélecteurs correspondants.

13. Mémoire non volatile selon la revendication 6, lesdites lignes étant couplées au moyen de pistes d'un premier niveau de métallisation et des dérivations de métallisation étant prévues, en nombre égal à celui des paires de lignes de mots (WL) se référant à une piste de métallisation d'un deuxième niveau de métallisation.

14. Procédé d'exploitation d'une mémoire non volatile selon la revendication 1, le procédé comportant les étapes consistant à :
court-circuiter ladite première partie physique (23) au moins vers ladite deuxième partie physique (23a),
et découpler de manière capacitive les première (23) et deuxième (23a) parties physiques à l'aide d'un commutateur (29) de découplage.

15. Procédé selon la revendication 14, la nième ligne d'un secteur physique étant couplée à la nième ligne du secteur physique adjacent, les lignes couplées occupant la même position dans les secteurs physiques respectifs.

16. Procédé selon la revendication 14, les bornes de source des cellules de mémoire correspondantes de la paire de lignes reliées se référant à une même ligne de sélection (SSL) de ligne de source et au moins un même secteur logique de matrice comportant des paires de lignes couplées avec les lignes de chaque paire placées sur des parties opposées par rapport à ladite ligne de sélection (SSL) de ligne de source.
